# EUROPEAN PATENT APPLICATION

(11) **EP 1 662 323 A1**
(43) Date of publication of application: **31.05.2006**
(21) Application number: 04772165.9
(22) Date of filing: 25.08.2004
(51) Int. Cl.: G03F 7/11, G03F 7/039, H01L 21/027

(54) **MATERIAL FOR FORMING RESIST-PROTECTING FILM FOR IMMERSION EXPOSURE PROCESS, RESIST-PROTECTING FILM MADE OF SUCH MATERIAL, AND METHOD FOR FORMING RESIST PATTERN USING SUCH RESIST-PROTECTING FILM**

(30) Priority: 25.08.2003 JP 2003300666; 16.10.2003 JP 2003356963
(71) Applicant: TOKYO OHKA KOGYO CO., LTD., Kawasaki-shi, Kanagawa 211-0012 (JP)
(72) Inventor: , c/o TOKYO OHKA KOGYO CO., LTD., Kawasaki-shi, Kanagawa 211-0012 (JP); , c/o TOKYO IHKA KOGYO CO., LTD., Kawasaki-shi, Kanagawa 211-0012 (JP); YOSHIDA, Masaaki, c/o TOKYO OHKA KOGYO CO., LTD., Kawasaki-shi, Kanagawa 211-0012 (JP); WAKIYA, Kazumasa, c/o TOKYO OHKA KOGYO CO., LTD., Kawasaki-shi, Kanagawa 211-0012 (JP)
(74) Representative: HOFFMANN EITLE
(86) International application number: PCT/JP2004/012204
(87) International publication number: WO 2005/019937

(57) **Abstract**

The resist protective film forming material for liquid immersion lithography is provided, which is suitable when the non-aqueous solution with a high transparency and high refractive index exemplified by the fluorinated liquid is used. The resist protective film forming material includes at least one component selected from water-soluble and alkali-soluble film forming components. The liquid immersion lithography process improves the resolution of resist patterns by irradiating a light beam on a resist film interposing a given thickness of the non-aqueous solution with a refractive index higher than that of the air at least on the resist film in a path, along where the lithography exposing light beam passes to the resist film.

## Description

### TECHNICAL FIELD

The present invention relates to a material for forming resist protective film, a resist protective film formed by the material and a method of forming resist patterns using the material, suitably used in a "liquid immersion lithography" process, in particular in a liquid immersion lithography process, which has been designed so that the resolution of a resist pattern is improved by exposing the resist film in the presence of a non-aqueous solution of a given thickness with a refractive index larger than that of air at least on the resist film in a path, along which a lithographic exposing light beam passes to the resist film.

### BACKGROUND ART

Conventionally, a lithography has been commonly used in fabricating fine structures in a various kind of electronic devices such as semiconductor devices and liquid crystal devices, however, the need for a micro-fabrication of resist patterns in a lithography process has arisen as device structures have been miniaturized.

At present, the lithography enables fine resist patterns with a line width of approximately 90 nm (90 nm node) to be micro-fabricated, though further micro-fabrication of finer resist patterns will be needed in the future.

To achieve micro-fabrication of patterns of line widths finer than 90 nm, the success of the development of a photolithography machine and the resists suitable for the machine is the most important key. Focus is generally put on shortening the wavelengths of light sources, such as F₂ excimer laser, EUV (extreme ultraviolet radiation), electron beam, X-ray, and soft X-ray, as well as on increasing a numerical aperture (hereinafter, simply referred to as N/A) of lenses in developing the photolithography machine.

On the other hand, not only shortening the wavelengths of the light sources requires a new expensive photolithography machine but also a problem involved in increasing the NA arises in that a focal depth width is reduced even if the resolution is improved because a trade-off lies between increasing the resolution and the focal depth width.

Recently, a liquid immersion lithography, which is a lithography technique for enabling these problems to be solve, has been reported (for example, J. Vac. Sci. Technol. B, 1999, Vol.17, No.6, pp.3306-3309 (Nonpatent Document 1), J. Vac. Sci. Technol. B, 2001, Vol.19, No.6, PP.2353-2356(Nonpatent Document 2), and Proceedings of SPIE Vol.4691, 2002, Vo.4691, pp.459-465(Nonpatent Document 3)). In this method, a given thickness of liquid refractive index medium such as deionized water or fluorinated inactive liquid (refractive index liquid, liquid immersion liquid) is landed on at least a resist film between the lens and the resist film on a substrate in a lithography process. This method, by which instead of conventional inactive gas such as air or nitrogen, a liquid with a larger refractive index (n), for example, deionized water is filled in an exposing light beam path space, achieves high resolution as in the use of any of light sources with shorter wavelengths or any of high NA lenses, with no reduction in focal depth width even if the conventional light source with an existing wavelength is used.

This liquid immersion lithography draws special attention, which enables the resist patterns with a higher resolution and satisfactory focal depth to be formed at a lower cost even if the lenses attached to the existing machine are used.

In the aforementioned liquid immersion lithography process, however, the resist film comes in directly contact with the refractive index liquid (liquid immersion liquid) in the lithography process and thereby, undergoing an invasion by the liquid.

In making an attempt to solve this problem, the inventor et al. successfully achieved the formation of high-resolution resist patterns by liquid immersion lithography by temporarily forming a special protective film on the surface of the conventional resist film to prevent the resist film in the liquid immersion lithography, as well as the used liquid immersion liquid itself from deteriorations. Specifically, this special protective film could be obtained in the development process of the resist protective film forming material, which contains at least a fluorine-substituted polymer, for the liquid immersion lithography process.

Nonpatent Document 1: Journal of Vacuum Science & Technology B (J.Vac.Sci.Technol.B) (Published in USA), 1999, Vol.17, No.6, pp.3306-3309
Nonpatent Document 2: Journal of Vacuum Science & Technology B (J.Vac.Sci.Technol.B)(Published in USA), 2001, Vol.19, No.6, pp.2353-2356
Nonpatent Document 3: Proceedings of SPIE Vol.4691 (Published in USA), 2002, Vol.4691, pp.459-465

### DISCLOSURE OF INVENTION

### PROBLEM TO BE SOLVED BY THE INVENTION

However, the need for the formation of higher-resolution patterns with micro-sizes finer than or equal to 45 nm has arisen in the semiconductor industry. To satisfy this need, it is required to develop the liquid immersion lithography suitable for wavelengths lower than 193 nm, in particular 157 nm. In this context, serious efforts are being made in conducting the researches and developments on the liquid immersion lithography from each of the aspects of the liquid immersion liquid and the protective film resist.

Focusing on the liquid immersion liquid, with F₂ excimer laser beam (157 nm), the properties essential for the liquid immersion liquid are high transparency and high refractive index. It is known that non-aqueous solutions exemplified by fluorinated liquids are suitably used as the liquids having these properties.

The use of this type of fluorinated liquid as the liquid immersion liquid in applying liquid immersion at a wavelength of 157 nm may theoretically reduce the exposure wavelength to 120 nm. When, nevertheless, the' existing liquid immersion lithography, by which water (refractive index of approximately 1.46) is used as the liquid immersion liquid, is applied at a wavelength of 193 nm, the exposure wavelength is reduced only to 130 nm, a minor shrinkage (reduction in wavelength), approximately 10 nm, in the exposing light source being achieved compared with the aforementioned liquid immersion lithography (liquid immersion liquid: fluorinated liquid, wavelength: 157 nm).

From the viewpoint of labor effectiveness, it is impractical that various conditions are established for liquid immersion lithography to be applied using the fluorinated liquid as the liquid immersion liquid at the wavelength of 157 nm to achieve a negligible order of shrinkage (approximately 10 nm) in the exposing light source.

Considering the aforementioned point, it is required that the liquid immersion liquid with a refractive index of at least 1.5, preferably 1.7 be used to shrink the exposure wavelength to 90 nm for liquid immersion lithography at the wavelength of 157 nm to win a practical advantage over liquid immersion lithography using water as the liquid immersion liquid at the wavelength of 193 nm.

Any liquid immersion liquid, which has such a high refractive index, namely 1.5 or more, has not been put into practical use, though in the light of a recent technological trend, it may be a matter of time before a liquid immersion liquid with a high refractive index is developed among non-aqueous solutions exemplified by fluorinated liquids and put on the market. Thus, to enable finer (less than or equal to 45 nm node as aforementioned) and higher-resolution patterns to be formed, it is very important that the protective film suitable for the non-aqueous solution with a high refractive index, which will be arguably put on the market soon, is develop and put on the market prior to advent of such a liquid immersion liquid.

As mentioned above, the inventor et al. have successfully developed the material for forming of the resist protective film, which contains at least a fluorine-substituted polymer, however, the material is developed for protective film formation under consideration only of the aqueous solution immersion liquid and thereby, the resist protective film, which contains at least the aforementioned fluorine-substituted polymer, for liquid immersion lithography is eroded when the non-aqueous solution is selected as the liquid immersion liquid exemplified by the fluorinated liquid. Accordingly, the resist film comes in directly contact with the refractive index liquid (liquid immersion liquid) in the exposure process, being eroded by the liquid. This results in deterioration in the resist film and/or of the used liquid itself in the liquid immersion lithography process. Accordingly, the protective film previously developed by the inventor(s) is not suitable for practical use.

### MEANS FOR SOLVING PROBLEM

To solve the aforementioned problem, the present inventors devoted themselves to the study on the resist protective film forming material for liquid immersion lithography, which is suitable when the non-aqueous solution with a high transparency and high refractive index exemplified by the fluorinated liquid is used. The result of the study revealed that by adding at least one elected from aqueous and alkali-soluble components for film formation to form the resist protective film for liquid Immersion, the film is not eroded by the fluorinated liquid. Base on this knowledge, the inventors have successfully finalized the present invention.

The present invention is based on the aforementioned knowledge, and a resist protective film forming material for a liquid immersion lithography process according to the present invention is characterized in that the resist protective film forming material for a liquid immersion lithography process for forming the resist protective film suitably used for the liquid immersion lithography process, in which a light beam is selectively irradiated on the resist film through a non-aqueous solution, includes at least one component selected from water-soluble and alkali-soluble film forming components.

In the above constitution, it is especially preferable that the liquid immersion lithography process improves the resolution of resist patterns by irradiating a light beam on a resist film interposing a given thickness of the non-aqueous solution with a refractive index higher than that of the air at least on the resist film in a path, along where the lithography exposing light beam passes to the resist film.

The resist protective film for a liquid immersion lithography process according to the present invention is characterized in that the resist protective film for a liquid immersion lithography process is suitably used in the liquid immersion lithography process, in which a light beam is selectively irradiated on the resist film through the non-aqueous solution, the resist protective film forming material is formed on the resist.

A method of forming resist patterns using a liquid immersion lithography process according to the present invention includes the steps of: forming a resist film on a substrate; forming a protective film composed of the resist protective film forming material according to claim 1 on the resist film; laying a given thickness of non-aqueous solution for liquid immersion lithography directly on at least the protective film of the substrate, on which the resist film and the resist protective film are formed; selectively irradiating a light beam on the resist film through the non-aqueous solution for liquid immersion lithography and the protective film, and subjecting a heat treatment if necessary; and developing the resist film after irradiation and simultaneously removing the protective film to obtain resist patterns.

Moreover, the present invention provides a resist protective film suitable for liquid immersion lithography, and has a subsidiary effect in that the protective film formed on the resist film prevents an acidic component on the surface of the resist film from being inactivated when coming in contact with amine in the air prior to the liquid immersion lithography. In other words, it is known that in an environment where approximately 5 ppb concentration of amine is contained in the air, the acidic component is inactivated when the resist film is exposed to the light beam, leading to deterioration in resist pattern. The use of the protective film of the present invention may improve a durability of the resist film to any of environmental factors such as the aforementioned amine in the air.

In addition, a coating liquid for resist film composed of water-soluble film forming components and at least one selected from acidic compounds and acid generating reagent, and the resist material using them (hereinafter, simply referred to as "disclosed resist material") are disclosed in Japanese Patent Application Laid-Open No. 8-15859 filed by the present inventors. The disclosed resist material has been developed with an object of "providing the coating liquid for forming the resist film, which may keep sufficient effects of antireflection film to address the recent movement toward the micro-fabrication in the microchip manufacturing industry, as well as may prevent equipment including devices, to which the coating liquid is applied, from being eroded; or providing the coating liquid for forming the resist film, which enables the homogeneity of an interference-protective film to be improved to form the interference-protective film with no irregularity in the coated layer, achieving the resist patterns exactly similar to the mask patterns; and providing the resist material using these coating liquids for resist film formation". Therefore, the disclosed resist material is apparently different from the present invention in terms not only of the object of an invention, the object of the latter being to provide the resist protective film suitable for liquid immersion lithography, but also of the function and effects.

The resist protective film forming material for a liquid immersion lithography process of the present invention has been achieved from the result of investigating the components thoroughly, which may most suitably indicate their resistance to the non-aqueous solution, in an absolutely unpredictable situation because liquid immersion lithography is a special lithography technique. Therefore, the present invention is established independently from the invention disclosed in the aforementioned patent document. In this connection, an idea of the liquid immersion lithography technique was not suggested in the aforementioned patent document and accordingly, it is unknown at all whether the disclosed resist material is applicable to liquid immersion lithography or not.

The present inventors, in establishing the present invention, analyzed a method of evaluating the applicability of the resist film in using the resist pattern forming method involving liquid immersion lithography process in a manner described below and based on the result of the analysis, the resist components and the method of forming the resist patterns using these components were evaluated.

In other words, it may be determined that simply by confirming three important factors, namely, (i) the performance of an optical system according to the liquid immersion lithography, (ii) the effects of the resist film on the liquid immersion liquid, and (iii) any deterioration in the resist film caused by the liquid immersion liquid, the performance of resist pattern formation by liquid immersion lithography may be sufficiently evaluated.

As known, for example, when the case is assumed where a photosensitive plate, of which surface is waterproof, for photograph is immersed into water and a patterning light beam is irradiated onto the surface, it is in principle undoubted with respect to the factor (i) the performance of an optical system that no problem occurs if no loss in light propagation occurs on the water surface and at the interface between the water and the surface of the photosensitive plate. In this case, a problem of the loss in light propagation may be easily solved simply by suitably correcting an incidence angle of the exposing light beam. Accordingly, regardless of the resist film or the photosensitive plate for photograph or a imaging screen being exposed, no deterioration may occur in the performance of the optical system provided that the optical system is insensitive to the liquid immersion liquid, namely it is not affected by the liquid immersion liquid and vice versa. Thus, it is not necessary to further confirm this factor or conduct an experiment on it.

With respect to the factor (ii) the effects of the resist film on the liquid immersion liquid, specifically, the components of the resist film are dissolved into the liquid immersion liquid, thereby changing the refractive index of the liquid. It is theoretically clear that a change in refractive index of the liquid immersion liquid affects the optical resolution performance of pattern exposure even if no experiment is conducted. This factor may be sufficiently confirmed simply by verifying that a component has been dissolved from the resist film into the liquid immersion liquid or the refractive index has changed when the resist film is immersed into the liquid immersion liquid. Therefore, it is not necessary that actually, a patterning light beam is irradiated and then the resist film is developed to check the resolution performance.

In contrast, when the patterning light beam is irradiated the resist film in the liquid immersion liquid and then the resist film is developed to check the resolution performance, it can not identified whether the resolution performance has been affected by the degenerated liquid or by the degenerated resist film or both even if it may be confirmed whether the resolution performance is satisfactory or not.

With respect to the factor (iii) any degeneration in the resist film caused by the liquid immersion liquid, any deterioration in resolution performance due to degeneration in the resist film may be sufficiently evaluated simply by conducting such an experiment "the liquid immersion liquid is poured on the resist film between the process of selective exposure and the process of post-exposure baking (PEB), for example in the form of shower, for bringing into contact with the resist film followed by developing the resist film to make a test on the resolution performance of the resulting resist patterns". With this evaluation method, however, the liquid immersion liquid is poured directly on the resist film, which is a harsher condition for liquid immersion. From the result of the test, in which the resist film immersed into the liquid is exposed to the light beam, it is not clarified whether any deterioration in the resist components has been caused by the degenerated liquid immersion liquid or by the degenerated resist components due to the liquid immersion liquid, or by both of them.

The aforementioned factors (ii) and (iii) are inextricably linked and therefore, both of them may be recognized by verifying the degree of the degeneration of the resist patterns or sensitivity caused by the liquid immersion liquid. This means that only by making an evaluation on the factor (iii), one of other factors (ii) may be consequently verified.

Based on the result of this analysis, the applicability of the resist protective film to liquid immersion lithography formed a new film forming material suitable for liquid immersion lithography was confirmed by conducting an evaluation test (hereinafter, simply referred to as "evaluation test 1"), in which for example "the liquid immersion liquid is poured like a shower on the resist film between the process of selective exposure and the process of post-exposure baking (PEB), for bringing into contact with the film followed by developing the resist film to make a test on the resolution performance of the resulting resist patterns".

Moreover, another evaluation test (hereinafter, simply referred to as "evaluation test 2"), in which an actual manufacturing process was simulated, "instead of the exposing light beam for patterning, an interference light beam through a prism is used to immerse samples (the resist films covered with the protective films) into the liquid immersion liquid for lithography (double-beam interference lithography)".

Furthermore, the resistance of the resist protective film to the liquid immersion liquid was confirmed by conduction the evaluation test (hereinafter, simply referred to as "evaluation test 3") using the Quarts Crystal method (the film thickness measurement method using a Quarts Crystal Microbalance) to detect an extremely negligible degree of change in film thickness based on a change in film weight.

### EFFECT OF THE INVENTION

According to the present invention, the resist protective film forming material for liquid immersion lithography process, which may be suitably used in the liquid immersion lithography process using a non-aqueous solution with a high transparency and high refractive index exemplified by a fluorinated liquid, and the resist protective film composed of the resist protective film forming material may be provided. In addition, according to the present invention, the method of forming resist patterns using the liquid immersion lithography process, which involves a step of providing the resist protective film made of the resist protective film forming material, may be provided.

Now, embodiments of the present invention are described below.
(I) The resist protective film forming material for a liquid immersion lithography process
   The resist protective film forming material for a liquid immersion lithography process of the present invention is characterized in that the resist protective film forming material for a liquid immersion lithography process is for forming the resist protective film suitable for the liquid immersion lithography process, in which a light beam is selectively irradiated on the resist film through a non-aqueous solution, and includes at least one component selected from water-soluble and alkali-soluble film forming components.

Any of water-soluble or alkali-soluble film forming components with transparency to the irradiated light beam may be used for the resist protective film forming material for liquid immersion lithography of the present invention with no special limitation, though, for example, the component is preferably used, which may satisfy the conditions that; i) a homogeneous coated film can be formed by a commonly used coating method such as the spin coating method, ii) no degenerated layer is formed on the photo resist film even if the component is coated on the film, iii) an activated light beam can be sufficiently transmitted through the component, and iv) a transparent coated film with a small absorption index can be formed.

This type of water-soluble film forming components include, for example, cellulosic polymers including hydroxypropylmethylcellulose phthalate, hydroxypropylmethylcellulose acetatephthalate, hydroxypropylmethylcellulose acetatesuccinate, hydroxypropylmethylcellulose hexahydrophthalate, hydroxypropylmethylcellulose, hydroxypropylcellulose, hydroxyethylcellulose, celluloseacetatehexahydrophthalate, carboxymethylcellulose, ethylcellulose, and methylcellulose; acrylic acid polymers, of which monomers are N,N-dimethylacrylamide, N,N-dimethylaminopropylmethacrylamide, N,N-dimethylaminopropylacrylamide, N-methylacrylamide, diacetoneacrylamide, N,N-dimethylaminomethacrylate, N,N-diethylaminoethylmethacrylate, N,N-dimethylaminoethylacrylate, acryloylmorpholine, acrylic acid, and others; and vinylic polymers including polyvinyl alcohol and polyvinylpyrrolidone. Among these components, the acrylic polymers and polyvinylpyrrolidone, which are water-soluble polymers with no hydroxyl group in their molecular structure, are suitable. These water-soluble film forming components may be used alone or by combining two or more.

The alkali-soluble film forming components used for the resist protective film forming material for liquid immersion lithography of the present invention include, for example, novolak resin, which is obtained by condensing phenols (phenol, m-cresol, xylenol, trimethylphenol or the like) with aldehydes (formaldehyde, formaldehyde precursor, propionaldehyde, 2-hydroxybenzaldehyde, 3-hydroxybenzaldehyde, 4-hydroxybenzaldehyde or the like) and/or ketones (methylethylketone, acetone or the like) in the presence of an acidic catalyst; and hydroxystyrene resins including homopolymer of hydroxystyrene, copolymers of hydroxystyrene and other styrene polymer, and coplymers of hydroxystyrene and acrylic acid or methacrylic acid or their derivatives. These alkali-soluble film forming components may be used alone or by combining two or more.

Among the aforementioned water-soluble film forming components and alkali-soluble film forming components, the water-soluble film forming components are preferable for the resist protective film forming material for a liquid immersion lithography of the present invention.

The resist protective film forming material for a liquid immersion lithography of the present invention may further contain at least one component selected from acid generating reagents and acidic compounds. Any known compound, which is used for an amplification type resist, may be used for the acid generating reagents added in the resist protective film forming material for liquid immersion lithography of the present invention. Actual examples of the compounds include onium salts including diphenyliodoniumtrifluoromethanesulfonate, (4-methoxyphenyl)phenyliodoniumtrifluoromethanesulfonate, bis(p-tert-butylphenyl)iodoniumtrifluoromethanesulfonate, triphenylsulfoniumtrifluoromethanesulfonate, (4-methoxyphenyl)diphenylsulfoniumtrifluoromethanesulfonate, (4-methylphenyl)diphenylsulfoniumtrifluoromethanesulfonate, (4-methylphenyl)diphenylsulfoniumnonafluorobutanesulfonate, (p-tert-butylphenyl)diphenylsulfoniumtrifluoromethanesulfonate, diphenyliodoniumnonafluorobutanesulfonate, bis(p-tert-butylphenyl)iodoniumnonafluorobutanesulfonate, triphenylsulfoniumnonafluorobutanesulfonate, (4-trifluoromethylphenyl)diphenylsulfoniumtrifluoromethanesulf onate, (4-trifluoromethylphenyl)diphenylsulfoniumnonafluorobutanesulf onate, and tri(p-tert-butylphenyl)sulfoniumtrifluoromethanesulfonate.

Examples of the acidic compounds added in the resist protective film forming material for a liquid immersion lithography of the present invention include, for example, inorganic acids such as hydrochloric acid, sulfuric acid, nitric acid, and phosphoric acid; and organic acids such as formic acid, acetic acid, propionic acid, benzenesulfonic acid, and toluenesulfonic acid. These compounds may be used alone or by combining two or more of them.

Among the aforementioned acidic compounds, the preferable acids include: the compounds represented by the following general formula (1),

R₁fCOOH (1)

(in the general formula (1), R₁f is a fluorinated hydrocarbon group, where a part of or all of the hydrogen atoms of a saturated or unsaturated hydrocarbon group containing 1 to 20 carbon atoms are substituted with fluorine atoms); the compounds represented by the following general formula (2),

R₁fSO₃H (2)

(in the general formula (2), the definition of R₁f is same as described above); and the compounds represented by the following general formula (3),

R₂f(SO₂R₁f)n (3)

(in the general formula (3), the definition of R₁f is same as described above, R₂f is a fluorinated hydrocarbon group or a fluorinated amino group, where the hydrogen atoms of a saturated or unsaturated hydrocarbon group containing 1 to 20 carbon atoms are substituted with fluorine atoms or a hydrocarbon group or an amino group with no substitution, and n is an integer from 1 to 4).

Here, fluorinated carboxylic acids represented by the aforementioned general formula (1) include perfluoroheptanoic acid and perfluorooctanoic acid, and sulfonic acids substituted with fluorine atoms represented by the aforementioned general formula (2) include perfluoropropylsulfonic acid, perfluorooctylsulfonic acid, perfluorodecilesulfonic acid or the like. Specifically, for example, perfluoroheptanoic acid has been put on the market under the product name of EF-201 or the like, and perfluorooctylsulfonic acid under the product name EF-101 or the like (both of the compounds are manufactured by Tohkem Products Co., Ltd.) and therefore, these compounds may be suitably used.

fluorinated sulfonyl compounds represented by the aforementioned general formula (3) include tris(trifluorometylsulfonyl)methane, bis(trifluorometylsulfonyl)ammonium, and bis(heptafluoroetylsulfonyl)ammonium.

If it is required that the acidity of the protective film be increased, a sulfonic acid and/or a sulfonyl compound, in which one to four carbon atoms have been substituted with fluorine atoms, may be combined with a sulfonic acid and/or a sulfonyl compound, in which five or more carbon atoms have been substituted with fluorine atoms.
The addition of any of these acidic compounds and/or acid generating reagents may improve the resist pattern shape and avoid a problem of destabilization of the resist pattern with time.

The aforementioned resist protective film forming material for liquid immersion lithography of the present invention is usually used in the form of an aqueous solution. The contents of the water-soluble and the alkali-soluble film forming components is preferably 0.5 to 10.0% by weight and the content of at least one selected from the aforementioned acid generating reagents and the acidic compounds is preferably 1.0 to 15.0% by weight.
The pH value of the finally produced resist protective film forming material for liquid immersion lithography is not limited to a certain range of values, however, it is preferably an acidic value. From the aspect that a reduction in pattern film is improved, enhancing the rectangular shape of the pattern, the pH value is further preferably 2.4 to 2.8.

The aforementioned resist protective film forming material for liquid immersion lithography of the present invention may further include a nitrogen containing compound. Suitable nitrogen containing compounds include, for example, quaternary ammonium hydroxide compounds, alkanolamine compounds, and amino acid derivatives.

The quaternary ammonium hydroxide compounds include tetramethylammonium hydroxide, tetraethylammonium hydroxide, tetrapropylammonium hydroxide, tetrabutylammonium hydroxide, methyltripropylammonium hydroxide, and metyltributylammonium hydroxide.

The alkanolamine compounds include, for example, monoethanolamine, diethanolamine, triethanolamine, 2-(2-aminoethoxy)ethanol, N,N-dimethylethanolamine, N,N-diethylethanolamine, N,N-dibutylethanolamine, N-methylethanolamine, N-ethylethanolamine, N-butylethanolamine, N-methyldiethanolamine, monoisopropanolamine, diisopropanolamine and triisopropanolamine.

The amino acid derivatives include, for example, glycine, alanine, valine, leucine, isoleucine, proline phenylalanine, tryptophan, methionine, serine, threonine, cysteine, tyrosine, asparagine, glutamine, asparaginic acid, glutamic acid, lysine, arginine, histidine, 4-hydroxyproline, desmosine, γ-aminobutyl acid, and β-cyanoalanine.

An addition of the nitrogen containing compound enables the pH value for the resist protective film forming material to be finely adjusted, thereby achieving the improved shape of the resist pattern.

As described above, the resist protective film forming material for liquid immersion lithography of the present invention is usually used in the form of an aqueous solution. The addition of an alcoholic organic solvent such as isopropyl alcohol in the aqueous solution improves the dissolubility of at least one component selected from the acidic compounds and acid generating reagents, enhancing the homogeneity of the coated film and therefore, the alcoholic organic solvent may be added, if necessary. An amount of the added alcoholic organic solvent may be selected from the range up to 20% by weight relative to the total amount of the coating liquid. In addition, a various types of additives may be added to the resist protective film forming material, if desired, to improve the characteristics of the coated film to the extent that the object of the present invention is not infringed.

At least one selected from anion surfactants represented by the following general formula (4) may be contained in the resist protective film forming material for liquid immersion lithography of the present invention, if necessary, in addition to the aforementioned components.

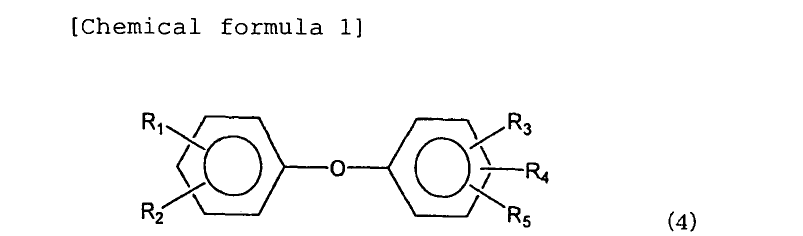

In the general formula (4), at least one of R₁ and R₂ is an alkyl group or alkoxy group with 5 to 18 carbon atoms and the other is an alkyl group or alkoxy group with 5 to 18 carbon atoms or a hydrogen atom; at least one of R₃, R₄, and R₅ is a sulfonic acid ammonium group or a sulfonic acid-substituted ammonium group and the others are hydrogen atoms, a sulfonic acid ammonium group, or a sulfonic acid-substituted ammonium group.

In the general formula (4), at least one of R₃, R₄, and R₅ is a sulfonic acid ammonium group or a sulfonic acid-substituted ammonium group, which may be any of monosubstituted, di-substituted, tri-substituted, and tetra-substituted ammonium groups where a substituent includes, for example, -CH₃, -C₂H₅, -CH₂OH, and -C₂H₄OH. For multi-substituted ammonium groups, they may be substituted with the same substituent or different substituents.

Herein, It is suitable that in the aforementioned general formula (4), R₁ is an alkyl group or alkoxy group with 5 to 18 carbon atoms; R₂ is an alkyl group or alkoxy group with 5 to 18 carbon atoms or a hydrogen atom; R₃ is N-substituted or non-substituted sulfonic acid ammonium group represented by a general formula -SO₃NZ₄ (in the general formula, Z is independently a hydrogen atom, or an alkyl group or hydroxyalkyl group with one to two carbon atoms, respectively); R₄ and R₅ are hydrogen atoms, respectively or the N-substituted or non-substituted sulfonic acid ammonium group represented by the general formula -SO₃NZ₄ (where, Z is as defined above).

Examples of the anion surfactant represented by the general formula (4) include alkyl diphenyl ether sulfonic acid ammonium, alkyl diphenyl ether sulfonic acid tetramethyl ammonium, alkyl diphenyl ether sulfonic acid trimethyl ethanol ammonium, alkyl diphenyl ether sulfonic acid triethyl ammonium, alkyl diphenyl ether disulfonic acid ammonium, alkyl diphenyl ether disulfonic acid diethanol ammonium, and alkyl diphenyl ether disulfonic acid tetramethyl ammonium but not limited to them. The alkyl group in the aforementioned compounds contains carbon atoms 5 to 18 and may be substituted with alkoxy group containing 5 to 18 carbon atoms. Among the anion surfactant represented by the a forementioned general formula (4), ammonium alkyl diphenyl ether disulfonate is preferable, in which R₁ is the alkyl group with C₅ to C₁₈, R₂ is a hydrogen atom, R₃ and R₄ are -SO₃NH₄, respectively, and R₅ is a hydrogen atom. These anion surfactant may be used alone or by combining two or more.

In this way, by adding the anion surfactant represented by the aforementioned general formula (4) to the aqueous film forming components and at least one selected from the acidic compounds and the acid generating reagents to prepare a coating liquid for the resist film, a coating uniformity of an interference preventing film may be effectively improved to minimize unevenness in the coated surface, thereby achieving the resist patterns exactly similar to the mask patterns.

The amount of the added anion surfactant represented by the aforementioned general formula (4) is within the range of 500 to 10000 ppm, and preferably the range of 1000 to 5000 ppm in the coating liquid for the resist film, in which the aqueous film forming components and at least one selected from the acidic compounds and the acid generating reagents are dissolved.

Furthermore, the compound represented in the aforementioned general formula (4) may be combined with N-alkyl-2-pyrrolidone represented by the following general formula (5) to use as the coating liquid. This is preferable because the coated film with superior coating performance, which is homogeneous evenness at the edges of a substrate, may be yielded at a small amount of coating liquid.

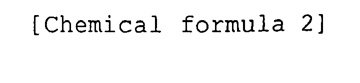

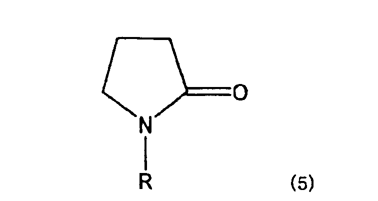

In the general formula (5), R is a alkyl group with 6 to 20 carbon atoms.

Examples of the compounds represented by the aforementioned general formula (5) include N-hexyl-2-pyrrolidone, N-heptyl-2-pyrrolidone, N-octyl-2-pyrrolidone, N-nonyl-2-pyrrolidone, N-decyl-2-pyrrolidone, N-undecyl-2-pyrrolidone, N-dodecyl-2-pyrrolidone, N-tridecyl-2-pyrrolidone, N-tetradecyl-2-pyrrolidone, N-pentadecyl-2-pyrrolidone, N-hexadecyl-2-pyrrolidone, N-heptadecyl-2-pyrrolidone, and N-octadecyl-2-pyrrolidone. Among these compounds, N-octyl-2-pyrrolidone and N-dodecyl-2-pyrrolidone are preferable because these compounds have been put on the market under the product names "SURFADONE LP100" and "SURFADONE LP300" by I.S.P. Japan Inc. and can easily be available.

The amount of the added compounds is within the range of 100 to 10000 ppm and preferably the range of 150 to 5000 ppm in the coating liquid, in which the aqueous film forming components and at least one selected from the acidic compounds and the acid generating reagents are dissolved.

The resist protective film forming material for liquid immersion lithography of the present invention is usually used in the form of aqueous solution as described above, however, an alcoholic organic solvent such as isopropyl alcohol may be added, if necessary, because this type of solvent improves the dissolubility of one selected from the acidic compounds and the acid generating reagents, as well as the homogeneity of the coated film. In such a case, it is suitable that the amount of the added alcohol organic solvent is selected in the range up to 20% by weight relative to the total amount of coating liquid. Moreover, a various kinds of additives may be added to the resist protective film forming material, if desired, to improve the characteristics of the film to the extent that no departure is made from the object of the present invention.

(II) Non-aqueous solution
As described above, the non-aqueous solution of the present invention is preferably a liquid with transparency to the exposing light beam used in the liquid immersion lithography process and a higher refractive index. In particular, the fluorinated liquid with any boiling point in the range of 70 to 260°C is preferable.

The immersion liquid made of the fluorinated liquid with these characteristics may provide a superior advantage in that (i) any variation in component ratio in the liquid immersion liquid and the liquid surface level due to its volatilization may be prevented in the liquid immersion lithography process carried out at a temperature around room temperature and a stable and suitable exposing light beam path being endured, because the immersion liquid has a boiling point higher than or equal to 70°C, and (ii) the immersion liquid may be easily and sufficiently removed in a convenient manner, for example, by means of drying at room, drying by spinning, drying by heating, and nitrogen blowing after the liquid immersion lithography process has been finished, because the immersion liquid has a boiling point lower than or equal to 260°C. With a higher dissolubility in gases such as oxygen and nitrogen, the aforementioned aqueous solution may effectively inhibit micro-bubbles or nano-bubbles from being generating, which adversely affect the lithography process.

The fluorinated liquid suitable for the non-aqueous solution of the present invention has the boiling point of any of the range of 70 to 260°C as described above and preferably the range of 80 to 160°C. Actual examples of this type of fluorinated liquid include perfluoroalkyl compounds, examples of which in turn, include perfluoroalkylether compounds and perfluoroalkylamine compounds.

An actual example of the aforementioned perfluoroalkylether compound includes perfluoro(2-butyltetrahydrofuran) (boiling pint of 102°C) and examples of the aforementioned perfluoroalkylamine compounds include perfluorotrihexylamine (boiling point of 255°C), perfluoropentylamine (boiling point of 215°C), perfluorotributylamine (boiling point of 174°C), and perfluorotripropylamine (boiling point of 130°C).

As described above, perfluoropolyether is proposed as the liquid immersion liquid in the non-patent document concerning liquid immersion lithography, namely the prior technical literature concerning liquid immersion lithography. In the process of developing the present invention, the present inventors discussed the usefulness of various kinds of commercially available products manufactured from the proposed perfluoropolyether from the aforementioned standpoint of development. Based on the result, it was revealed that no product has the boiling point, which is a factor determined to be an essential characteristic for the liquid immersion liquid by the inventors, of 180°C or lower and therefore, the liquid immersion liquid can not be sufficiently removed at least in the aforementioned convenient manner after the liquid immersion lithography process has been finished, thereby disturbing the formation of the resist patterns by the residual liquid immersion liquid.

These perfluoroalkylpolyether have a higher degree of dispersion in its molecular weight, which is a factor of adversely affecting the stabilization of the refractive index of the exposing light beam, as well as the optical stability in the conditions of lithography. In contrast, it is estimated that the liquid immersion liquid of the present invention, which has a relatively low degree of dispersion in its molecular weight, does not adversely affect optical stability of problem and therefore, the liquid of the present invention is a suitable for liquid immersion lithography.

A wavelength of the light beam for lithography used in the present invention is not limited to certain wavelengths and any radioactive ray of ArF excimer laser, KrF excimer laser, F₂ excimer laser, EUV (Extreme Ultraviolet Ray), VUV (Vacuum Ultraviolet Ray), Electron beam, X-ray, and soft X-ray may be used. The wavelength to be selected is depends mainly on the characteristics of the resist film. The non-aqueous solution exemplified by the fluorinated liquid has a higher transparency and therefore, the present invention may indicate its best usefulness when any short wavelength light beam such as F₂ excimer laser beam is used.

(III) Resist film
As described above, it is preferable that the resin component for forming the resist film used in the liquid immersion lithography process of the present invention is (A) a polymer, which has a alkali-soluble constitutional unit (a0-1) containing a cycloaliphatic group having both of (i) a fluorine atom or a fluorinated alkyl group and (ii) an alcoholic hydroxyl group and its alkali-solubility may be changed when an acid acts on it.

The aforementioned description "its alkali-solubility may be changed when an acid acts on it" means that the polymer changes in the light-exposed site and when the alkali-solubility increases at the light-exposed site, the light-exposed site became alkali-soluble and therefore, may be used for the positive resist film, while when the alkali-solubility decreased at the light-exposed site, the light-exposed site becomes alkali-insoluble and therefore may be used for the negative resist film.

The aforementioned alkali-soluble constitutional unit (a0-1) containing a cycloaliphatic group having both of (i) a fluorine atom or a fluorinated alkyl group and
(ii) an alcoholic hydroxyl group, may be any one provided that the aforementioned organic group having both (i) and
(ii) forms a chemical bond with the cycloaliphatic group, which is contained in the constitutional unit.

The cycloaliphatic group is exemplified by a group, in which one hydrogen atom or a plurality of hydrogen atoms have been removed from monocyclohydrocarbon or polycyclohydrocarbon including cyclopentane, cyclohexane, bicycloalkane, tricycloalkane, tetracycloalkane. More specifically, the polycyclic hydrocarbon is exemplified by a group, in which one hydrogen atom or a plurality of hydrogen atoms have been removed from a polycycloalkane including adamantane, norbornane, isobornane, tricyclodecane, and tetracyclododecane. Among these polycycloalkane, derived by removing one hydrogen atom or a plurality of hydrogen atoms from cyclopentane, cyclohexane, or norbornane, is preferable for industrial use.

The aforementioned (i) a fluorine atom and a fluorinated alkyl group are exemplified by the fluorine atom and the fluorinated alkyl group, in which some or all of hydrogen atoms have been substituted with fluorine atoms from a lower alkyl group, respectively. Specifically, this type of fluorinated alkyl group includes trifluoromethyl group, pentafluoroethyl group, heptafluoropropyl group, and nonafluorobutyl group. Among these atom and the groups, the fluorine atom and the trifluoromethyl group are preferable for industrial use.

The aforementioned (ii) an alcoholic hydroxyl group may be the hydroxyl group alone, or may be an alkyloxy group containing a hydroxyl group, an alkyloxy group containing any of alcoholic hydroxyl groups such as an alkyloxyalkyl group and alkyl group, an alkyloxyalkyl group containing the alcoholic hydroxyl group, and an alkyl group containing the alcoholic hydroxyl group. The alkyloxy group, the alkyloxyalkyl group, or the alkyl group is exemplified by a lower alkyloxy group, a lower alkyloxyalkyl group or a lower alkyl group, respectively.

The lower alkyloxy group is specifically exemplified by the methyloxy group, the ethyloxy group, the propyloxy group and the butyloxy group, the lower alkyloxyalkyl group is specifically exemplified by the methyloxymethyl group, the ethyloxymethyl group, the propyloxymethyl group, and the butyloxymethyl group, and the lower alkyl group is specifically exemplified by the methyl group, the ethyl group, the propyl group, and butyl group.

Alternatively, in the aforementioned (ii), the alkyloxy group containing the alcoholic hydroxyl group, the alkyloxyalkyl group containing the alcoholic hydroxyl group, or the alkyl group containing the alcoholic hydroxyl group, in which some or all of hydrogen atoms have been substituted with fluorine atoms may be used. Preferable examples include an alkyloxy group containing the alcoholic hydroxyl group or the alkyloxyalkyl group containing the alcoholic hydroxyl group, in which some of the hydrogen atoms have been substituted with the fluorine atoms in their alkyloxy group; and the alkyl group containing the alcoholic hydroxyl group, in which some of the hydrogen atoms have been substituted with fluorine atoms in the alkyl group, namely, any of the fluoroalkyloxy group containing the alcoholic hydroxyl group, fluoroalkyloxyalkyl group containing the alcoholic hydroxyl group, or the fluoroalkyl group containing the alcoholic hydroxyl group.

The aforementioned fluoroalkyloxy group containing the alcoholic hydroxyl group is exemplified by a (HO)C(CF₃)₂CH₂O-group, (2-bis(hexafluoromethyl)-2-hydroxy-ethyloxy group, (HO) C (CF₃)₂CH₂CH₂O-group, (3-bis(hexafluoromethyl)-3-hydroxy-propyloxy group; and the fluoroalkyloxyalkyl group containing the alcoholic hydroxyl group is exemplified by (HO) C (CF₃)₂CH₂O-CH₂-group, and (HO) C (CF₃)₂CH₂CH₂O-CH₂-group; and the fluoroalkyl group containing the alcoholic hydroxyl group is exemplified by (HO)C(CF₃)₂CH₂-group, (2-bis(hexafluoromethyl)-2-hydroxyethyl group, (HO)C(CF₃)₂CH₂CH₂-group, and (3-bis(hexafluoromethyl)-3-hydroxy-propyl group.

These groups in (i) and (ii) may be those, which form a direct bond with the aforementioned cycloaliphatic group. In particular, the fluoroalkyloxy group containing the alcoholic hydroxyl group, the fluoroalkyloxyalkyl group containing the alcoholic hydroxyl group, or the fluoroalkyl group containing the alcoholic hydroxyl group is bonded to the norbornene ring and then the double bond of the norbornene ring is cleaved to form the unit, which is represented by the following general formula (6) as the constituent unit (a0-1) is preferable because the unit has higher transparency, alkali-solubility, and resistance to dry etching, as well as industrially easy availability.

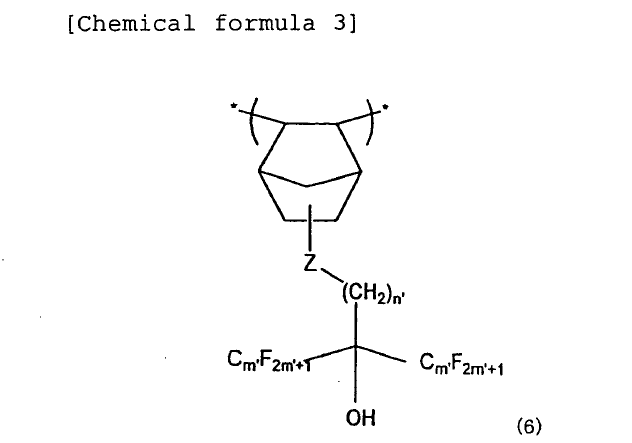

In the general formula (6), Z is an oxygen atom, an oxymethylene group(-O(CH₂)-), or a single bond, and n' and m' are independently any integer in the range of 1 to 5, respectively.

Any of polymeric units may be used in combination with this type of unit (a0-1) provided that these units are known. If a polymer (A-1), of which alkali-solubility increases when a positive type acid acts on it, is used, a constituent unit (a0-2), which is derived from (meta)acrylester containing a known acid-dissociative dissolution inhibiting group, is preferable because of its superior resolution.

This type of (a0-2) includes the constitutional unit derived from any of tertiary alkylesters of (meta)acrylic acid, for example, tert-butyl(meta)acrylate or tert-amyl(meta)acrylate.

Alternatively, the polymer (A) may be a polymer (A-2), which further contains fluorinated alkylene constitutional unit (a0-3) to improve the polymer's transparency and increase its alkali-solubility when an acid acts on it. By including this type of constitutional unit (a0-3), the transparency may be further improved. The constitutional unit (a0-3) is preferably any of units derived from tetrafluoroethylene.

General formulae (7) and (8) illustrating the polymer (A-1) and the polymer (A-2), respectively are shown below.

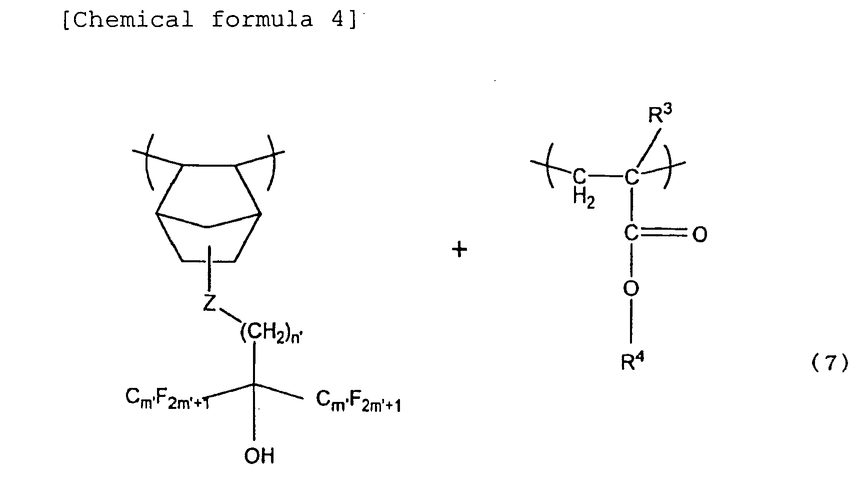

In the general formula (7), Z, n', m' are the same as that defined in the aforementioned general formula (6), R³ is a hydrogen atom or a methyl group, and R⁴ is acid-dissociative dissolution inhibiting group.

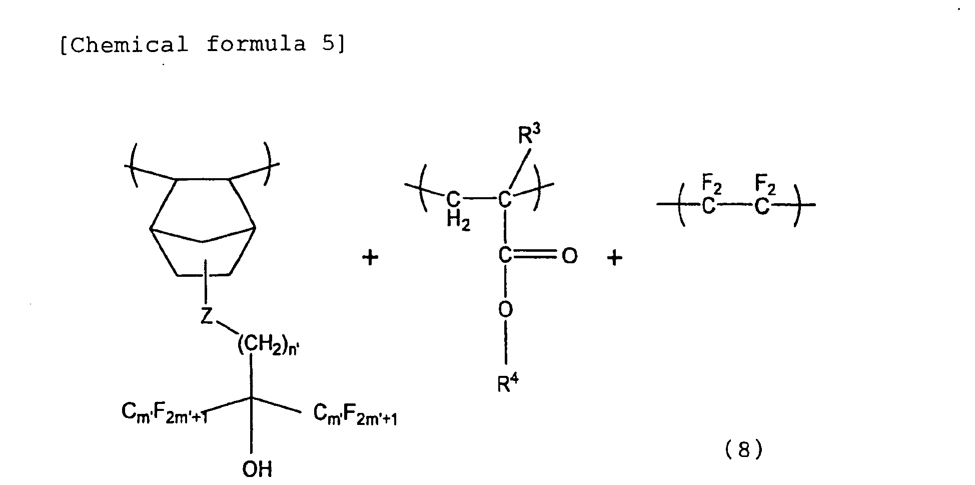

In a general formula (8), Z, n', m', R³ and R⁴ are the same as that defined in the aforementioned general formula (7).

The polymer (A-1) and the polymer (A-2), both of which contains the general formula (6), have different constitutional formulae, however, these polymers may be the polymers containing any of the following constitutional units, which contain an alkali-soluble constitutional unit (a0-1) containing the cycloaliphatic group having both (i) the fluorine atom or a fluorinated alkyl group and (ii) the alcoholic hydroxyl group and its alkali-solubility changes when the acid acts on it, this type of constitutional unit is assumed to be included in a concept of a polymer.

Namely, in this type of constitutional unit (a0-1),
(i) the fluorine atom and the fluorinated alkyl group and
(ii) the alcoholic hydroxyl group form the bond with the cycloaliphatic group, respectively, and the cyclic group constitutes a main chain for them. The aforementioned (i) fluorine atom or the fluorinated alkyl group include the same fluorine atoms or the fluorinated alkyl groups as described above and (ii) the alcoholic hydroxyl group is nothing but the hydroxyl group.

The polymer (A) having this type of constitutional unit is formed by cyclopolymerization of a diene compound having the hydroxyl group and the fluorine atom. The diene compound is preferably heptadiene, which tends to form a polymer having a 5-membered ring or 6-membered ring, and most preferably for industrial use a polymer having the 5-membered ring or 6-membered ring with higher transparency and resistance to dry etching, formed by cyclopolymerization of 1,1,2,3,3-pentafluoro-4-trifluoromethyl-4-hydroxy-1,6-heptadiene (CF₂=CFCF₂C (CF₃) (OH) CH₂CH=CH₂) .

A polymer (A-3), of which alkali-solubility increases when the acid acts on it, is used, a polymer, which contains a constitutional unit (a0-4), in which the hydrogen atom of the alcoholic hydroxyl group has been substituted with the acid-dissociative dissolution inhibiting group, is preferable. The acid-dissociative dissolution inhibiting group is preferable a chain, branch, or cyclic alkyloxymethyl group with 1 to 15 carbon atoms in terms of acid dissociation performance and in particular, preferably the lower alkoxymethyl group such as the methoxymethyl group because of its higher resolution and superior pattern shapes. It should be noted that the amount of the acid-dissociative dissolution inhibiting group is desirably within the range from 10 to 40% and preferably, the range from 15 to 30% relative to the total hydroxyl groups to achieve superior patterning performance.

A general formula (9) illustrating the polymer (A-3) is shown below.

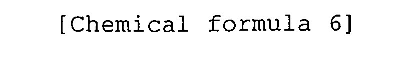

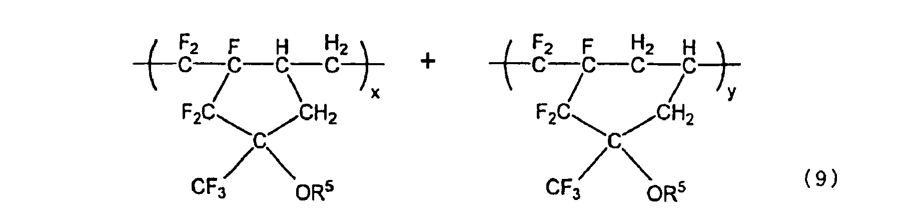

In the general formula (9), R⁵ is the hydrogen atom or the alkyloxymethyl group with C1 to C5 and x and y are 10 to 50 mol%, respectively.

This type of polymer (A) may be synthesized by a known method. The weight-average molecular weight of (A) component resin converted into polystyrene by means of a GPC is not limited special values but is preferably any in the range from 5000 to 80000 and further preferably in the range from 8000 to 50000.

The polymer (A) may be constituted using one kind of resin or two or more kinds of resins, for example, two or more resins selected from the aforementioned (A-1), (A-2), and (A-3) are mixed and used. Alternatively, known conventional resins for photo-resist composition may be mixed and used.

In the liquid immersion lithograph of the present invention, in addition to the resist composition made of the aforementioned resin components, commonly used the positive resist and the negative resist may be used. Actual examples of these resists are shown below.

First of all, the resin components used for the positive photo-resist include acrylic resin, cycloolefin resin, and silsesquioxane resin.

The aforementioned acrylic resin is preferable, for example, a resin, which has, for example, a constitutional unit (a1) derived from (meta)acrylic ester containing the acid-dissociative dissolution inhibiting group and the constitutional unit derived from any (meta)acrylic ester other than that of the constitutional unit (al) and contains the 80 mol% or more, preferably 90 mol% or more (100 mol% is the most preferable) of these constitutional units in total.

The aforementioned resin component is composed of a combination of a plurality of monomer units with different functions other than the aforementioned unit (a1), for example, a combination of constitutional units listed below to satisfy the need for high resolution, resistance to dry etching, and fine pattern shapes.

Namely, these constitutional units are a constitutional unit derived from (meta)acrylic ester having a lactone unit (hereinafter, simply referred to as a (a2) or (a2) unit), a constitutional unit (hereinafter, simply referred to as a (a3) or (3a) unit) derived from (meta)acrylic ester having a polycyclic group containing the alcoholic hydroxyl group, and a constitutional unit (hereinafter, simply referred t as (a4) or (4a) unit) containing a polycyclic group different from all of the acid-dissociative dissolution inhibiting group in the aforementioned (a1) unit, the lactone unit in the aforementioned (a2) unit, and the polycyclic group containing the alcoholic hydroxyl group in the aforementioned unit (a3) unit.

These (a2), (a3), and/or (a4) units may be combine, if applicable depending on the needed characteristics or the like. Preferably, at least one unit selected from (a1) and (a2), as well as at least one unit selected from (a3) and (a4) are contained to improve the resolution and resist pattern shapes. Alternatively, among the (a1) to (a4) units, different kinds of units may be combined and used.

It is preferable that the constitutional unit derived from meta acrylic ester and the constitutional unit derived from acrylic ester are used so that the constitutional unit derived from meta acrylic ester is 10 to 85 mol%, preferably 20 to 80 mol% and the constitutional unit derived from acrylic ester is 15 to 90 mol%, preferably 20 to 80 mol% relative to the total mol% of the constitutional unit derived from meta acrylic ester and the constitutional unit derived from acrylic ester.

Now, the aforementioned (a1) to (a4) units are described in detail.
The (a1) unit is a constitutional unit derived from (meta)acrylic ester containing the acid-dissociative dissolution inhibiting group. Any unit may be used with special limitation for the acid-dissociative dissolution inhibiting group in this (a1) unit provided that the unit has alkali-solubility inhibitive ability, which makes all the resin components alkali-insoluble prior to the lithography process and dissolves when a produced acid acts on it after the lithography process to change all the resin components alkali-soluble. Generally, the carboxyl group of (meta)acrylic acid, a group forming cyclic or chain tertiary alkyl ester, tertiary alkoxycarbonyl group, or chain alkoxyalkyl group is widely known.

For example, the acid-dissociative dissolution inhibiting group containing aliphatic polycyclic group is suitably used for the acid-dissociative dissolution inhibiting group in the aforementioned (a1) unit. The acid-dissociative dissolution inhibiting group is exemplified by bicycloalkane, tricycloalkane, and tetracycloalkane with or without hydrogen atoms being substituted with fluorine atoms, from which one hydrogen atom has been removed. Specifically, polycycloalkane including an adamantane, norbornane, isobornane, tricyclodecane, and tetracyclodecane, from which one hydrogen atom has been removed. This type of polycyclic group may be selected from many groups proposed for ArF resist. Among these groups, the adamantyl group, the norbolnyl group, the tetracyclododecanyl group is preferable for industrial use.

The monomer units suitable for the aforementioned (a1) unit are shown in the following general formulae (10) to (16). In these general formulae (10) to (16), R is a hydrogen atom or a methyl group, R₁ is a lower alkyl group, R₂ and R₃ are independently a lower alkyl group, respectively, R₄ is a tertiary alkyl group, R₅ is a methyl group, R₆ is a lower alkyl group. The aforementioned R₁ to R₃ and R₆ are preferably lower linear or branch alkyl groups with 1 to 5 carbon atoms, which are exemplified by a methyl group, an ethyl group, a propyl group, an isopropyl group, a n-butyl group, an isobutyl group, a tert-butyl group, a pentyl group, an isopentyl group, and a neopentyl group. The methyl group or the ethyl group is preferable for industrial use. R₄ is a tertiary alkyl group such as a tert-butyl group or a tert-amyl group and among them, a tert-butyl group is preferably for industrial use.

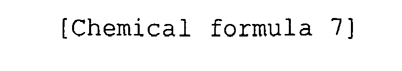

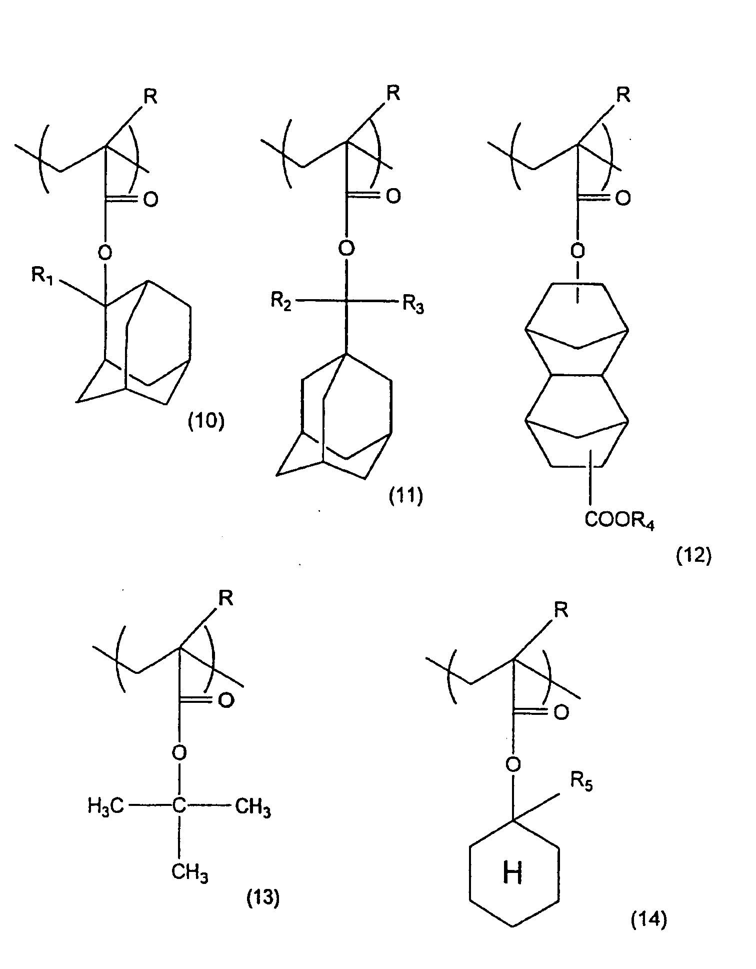

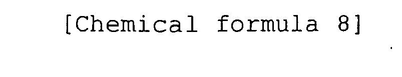

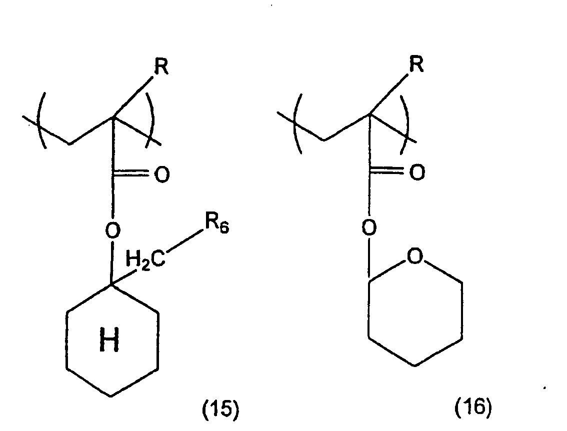

Among the constitutional units listed above for the (a1) unit, in particular, the constitutional units represented by the general formulae (10), (11), and (12) is further preferable because of their high transparency and resolution, as well as resistance to dry etching, achieving superior patterns.

The aforementioned (a2) unit, which has a lactone unit, is useful in improving hydrophilicity to a developing solution. Any of units, which have the lactone unit and may copolymerized with any other unit of the resin component, may be used for the (a2) unit. For example, the monocyclolactone unit includes the γ-butyrolactone group, from which one hydrogen atom has been removed. The polycyclolactone unit includes the polycycloalkane group containing lactone, from which one hydrogen atom has been removed.

Monomer units suitable for the aforementioned (a2) unit are shown in the following general formulae (17) to (19). In these general formulae, R is a hydrogen atom or a methyl group.

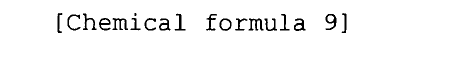

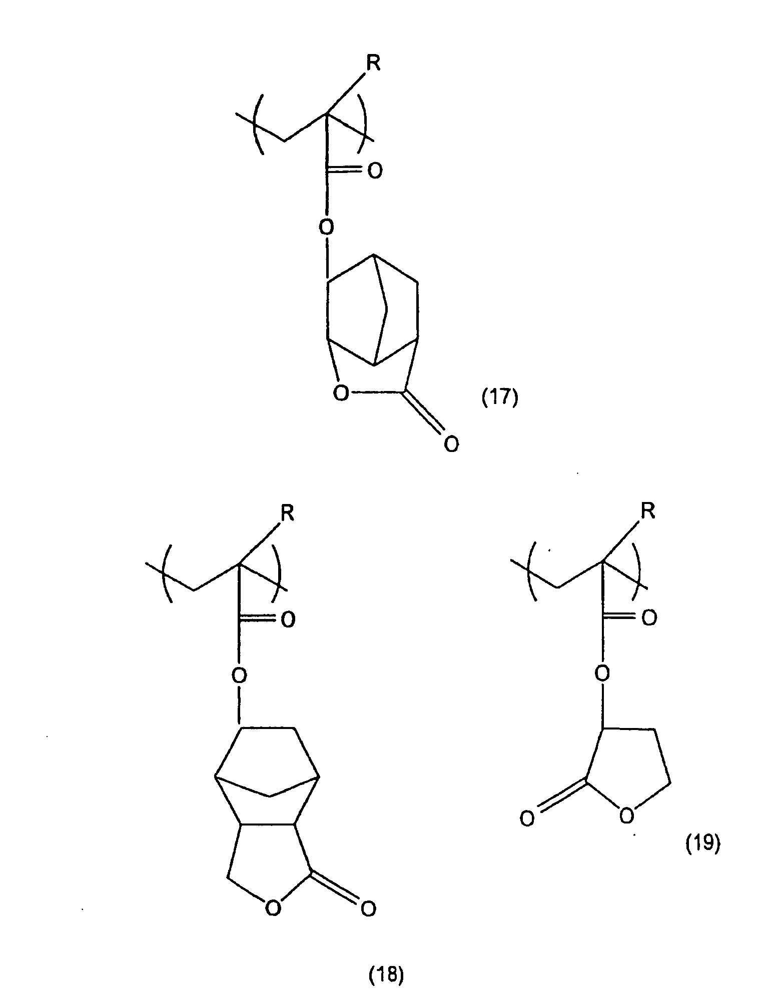

The γ-butyrolactone ester of (meta)acrylic acid, in which an ester bond is formed to an α-carbon, as shown in the aforementioned general formula (19) and norbornanelactone ester in the general formulae (17) and (18) are preferable for particular easy to industrial availability.

The aforementioned (a3) unit is a constitutional unit derived from (meta)acrylic ester having polycyclic group containing the alcoholic hydroxyl group. The hydroxyl group in the aforementioned polycyclic group containing the alcoholic hydroxyl group is a polar group and therefore, the use of this hydroxyl group improves the hydrophilicity of all the resin components to the developing solution, enhancing the alkali-solubility at the light-exposed site. Accordingly, it is preferable that the resin components, have the (a3) unit, which improve the resolution. The polycyclic group in the (a3) unit may be selected from the same aliphatic polycyclic groups as those exemplified in the description of the aforementioned (a1) unit and used.

Any group may be used without no special limitation for the polycyclic group containing the alcoholic hydroxyl group in the aforementioned (a3) unit and, for example, the adamantyl group containing the hydroxyl group or the like may be preferably used. It is preferable that if this adamantyl group containing the hydroxyl group may be represented by the following general formula (20), resistance to dry etching is improved, enhancing the verticality of the pattern cross section. In the general formula, 1 is any integer in the range of 1 to 3.

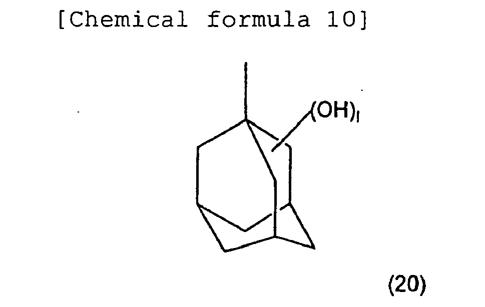

Any unit, which has the aforementioned polycyclic group containing the alcoholic hydroxyl group and may copolymerized with any other constitutional unit of the resin component, may be used for the aforementioned (a3) unit. Specifically, the constitutional unit represented by the following formula (21) is preferable. In the general formula (21), R is a hydrogen atom or a methyl group.

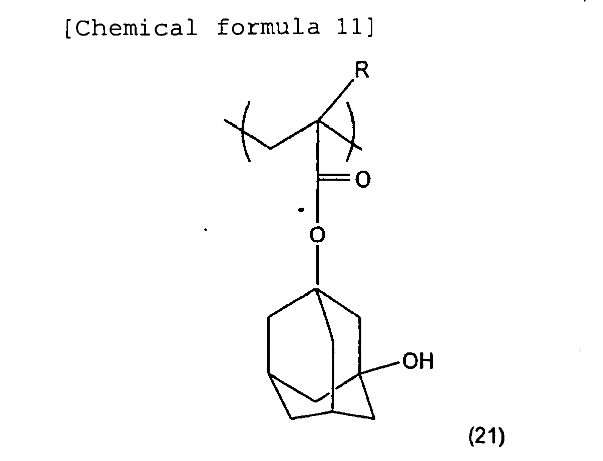

The description of the polycyclic group "different from all of the aforementioned acid-dissociative inhibiting group, the aforementioned lactone unit, and the polycyclic group containing alcoholic hydroxyl group" in the aforementioned (a4) unit means the polycyclic group, of which polycyclic group of the (a4) unit in the resin component is not the same as all of the aforementioned acid-dissociative inhibiting group of the (a1) unit, the aforementioned lactone unit of the (a2) unit, and the polycyclic group containing alcoholic hydroxyl group of the (a3) unit. In other words, the (a4) unit does not contain any of the aforementioned acid-dissociative inhibiting group of the (a1) unit, the aforementioned lactone unit of the (a2) unit, and the polycyclic group containing alcoholic hydroxyl group of the (a3) unit, all of which compose the resin component.

Any constitutional unit may be selected for the polycyclic group of the aforementioned (a4) unit with no special limitation provided that the unit is different from the constitutional units used as the aforementioned (a1) to (a3) units in one resin component. For example, the same aliphatic polycyclic group as the unit exemplified as the aforementioned (a1) unit may be used for the polycyclic group of the (a4) unit and any of many constitutional units conventionally known as a ArF positive resist material may be selected. In particular, it is preferable that at least one or more of the tricyclodecanyl group, the adamantyl group, and the tetracyclododecanyl group are selected because they are easy to industrial availability. Any unit may be used for the (a4) unit provided that the unit has the aforementioned polycyclic group and can be copolymerized with any other constitutional unit of the resin component.

A preferable examples of the aforementioned (a4) unit are shown in the general formulae (22) to (24). In these general formulae, R is a hydrogen atom or a methyl group.

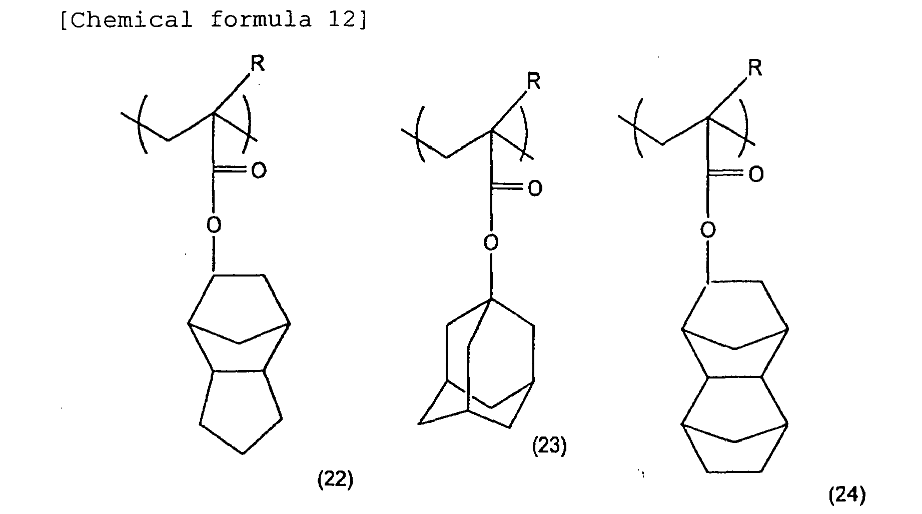

It is preferable that the (a1) unit is 20 to 60 mol%, preferably 30 to 50 mol% relative to the total of the constitutional units of the resin component because superior resolution may be achieved. It is preferable that the (a2) unit is 20 to 60 mol%, preferably 30 to 50 mol% relative to the total of the constitutional units of the resin component because of superior resolution may be achieved. Moreover, it is preferable that the (a3) unit, if being used, is 5 to 50 mol%, preferably 10 to 40 mol% relative to the total of the constitutional units of the resin component because superior resist patterns shapes may be achieved. Furthermore, it is preferable that the (a4) unit, if being used, is 1 to 30 mol%, preferably 5 to 20 mol% because superior higher resolution from isolated patterns into semi-dense patterns may be achieved.

The (a1) unit and at least one unit selected from the (a2) unit, the (a3) unit and the (a4) unit may be combined depending on the purpose if appropriate, however, preferably, a ternary polymer composed of the (a1) unit, the (a2) unit, and the (a3) unit has superior characteristics in terms of resist pattern shapes, lithographic flexibility, heat resistance, and resolution. In this case, the preferable contents of the constitutional units (a1) to (a3) are 20 to 60 mol%, 20 to 60 mol%, and 5 to 50 mol%, respectively.

On the other hand, the weight-average molecular weight of the resin component (converted into that of polystyrene, hereinafter the same) is not particularly limited but is preferably any in the range form 5000 to 30000 and is further preferably any in the range from 8000 to 20000. The value larger than this range may deteriorate the dissolution of the resin component into the resist solvent, while the value smaller may adversely affect resistance to dry etching and the cross sectional shapes of resist patterns.

The aforementioned cycloolefin resin is preferably a resin, which is synthesized by copolymerizing the constitutional unit (a5) shown in the following general formula (25) and the constitutional unit obtained from the (a1) unit, if necessary.

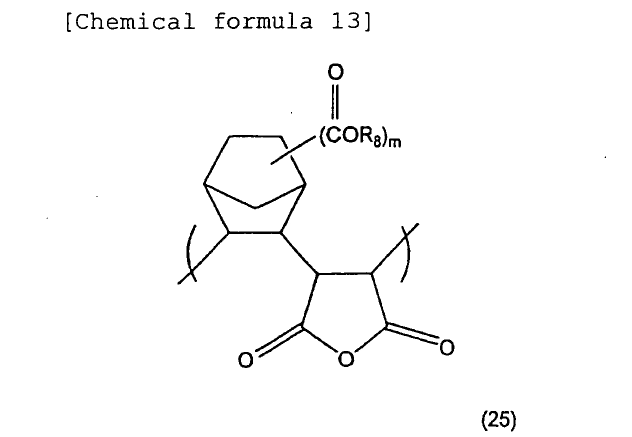

In the general formula (25), R₈ is a substituent group exemplified by the acid-dissociative dissolution inhibiting group in the description of the aforementioned (a1) unit and m is an integer from 0 to 3. If m is 0 (zero) in the aforementioned (a5) unit, the substituent group is preferably used as a copolymer having the (a1) unit.

In addition, the aforementioned silsesquioxane resin is exemplified by the resin components having the constitutional unit (a6) represented by the following general formula (26) and the constitutional unit (a7) represented by the following formula (27).

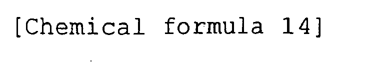

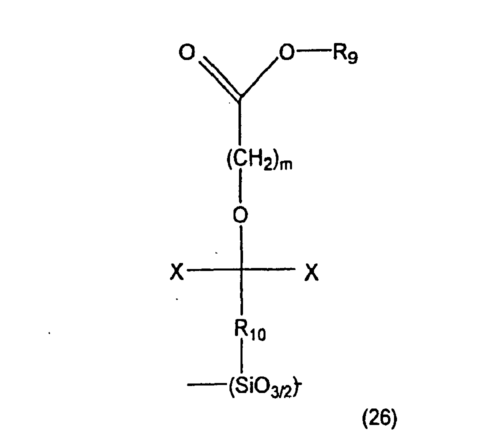

In the general formula (26), R₉ is an acid-dissociative dissolution inhibiting group composed of the hydrocarbon group containing the aliphatic monocyclic group or the polycyclic group, R₁₀ is the linear, branch, or cyclic saturated aliphatic hydrocarbon group, X is an alkyl group with one to eight carbon atoms, of which at least one of the hydrogen atoms has been substituted with the fluorine atom, and m is an integer from 1 to 3.

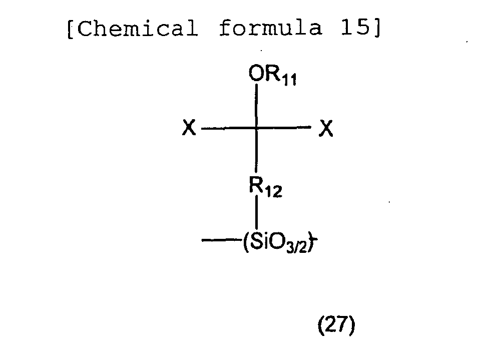

In the general formula (27), R₁₁ is a linear, branch, or cyclic alkyl group, R₁₂ is a linear, branch, or cyclic saturated aliphatic hydrocarbon group, X is an alkyl group with one to eight carbon atoms, of which at least one of the hydrogen atoms has been substituted with the fluorine atom.

In the aforementioned (a6) and (a7) units, the acid-dissociative dissolution inhibiting group represented by R₉ is a group, which has alkali-solubility inhibitive property to make all the silsesquioxane resin components alkali-insoluble prior to the lithograph process, as well as dissociates the silsesquioxane resin components by the action of an acid produced from the acid generating reagent after the lithography process, thereby making all the silsesquioxane resin alkali-soluble.

Such a group includes, for example, the acid-dissociative dissolution inhibiting group composed of a hydrocarbon group containing bulky aliphatic monocyclic or polycyclic group as shown in the following general formulae (28) to (32). The use of this acid-dissociative dissolution inhibiting group makes the dissociated dissolution inhibiting group difficult to gasify, preventing the group from degasifying phenomenon.

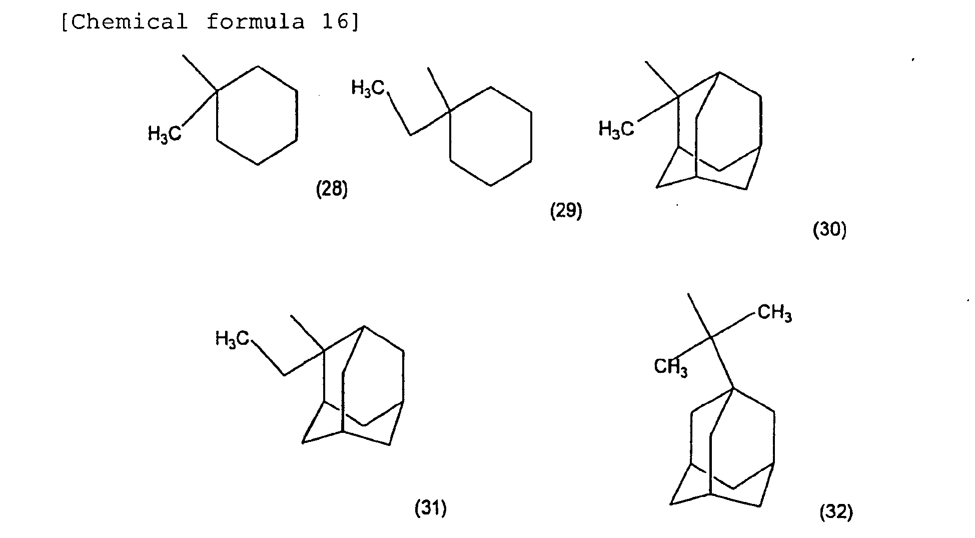

In the general formula (26), the number of the carbon atoms in R₉ is preferably 7 to 15 and more preferably 9 to 13 in terms of difficulty to gasify when dissociating, a moderate solubility in the resist solvent, and a solubility in the developing solution.

For the aforementioned acid-dissociative dissolution inhibiting group, any one may be selected from, for example, the many kinds of resin components proposed for resist composition for ArF excimer laser depending on the light source to be used as long as the component is the acid-dissociative dissolution inhibiting group composed of the hydrocarbon group containing the aliphatic monocyclic or polycyclic group. Generally, the components, which form tertiary alkyl ester with the carboxyl group of (meta)acrylic acid are widely known.

In particular, the acid-dissociative dissolution inhibiting group containing the aliphatic polycyclic group is preferably selected. For the aliphatic polycyclic group, any one may be selected and used from the many components proposed for the ArF resist. For example, the aliphatic polycyclic group includes the bicycloalkane, tricycloalkane, or tetracycloalkane group, of which one hydrogen atom has been removed, and more specifically, the polycycloalkane groups including adamantane, norbornane, isobornane, tricyclodecane, and tetracyclododecane, of which one hydrogen atom has been removed.

Among the aforementioned general formulae, silsesquioxane resin having a 2-methyl-2-adamantyl group represented by the general formula (30) and/or a 2-ethyl-2-adamantyl group represented by the general formula (31), which is difficult to degasify and has superior resist characteristics such as higher resolution and heat resistance, is preferably selected.

In addition, the number of the carbon atoms in the aforementioned R₁₀ and R₁₂ are preferably 1 to 20 and more preferably, 5 to 12 in terms of solubility to the resist solvent and control over molecular size. In particular, the cyclic saturated aliphatic hydrocarbon group, which has an advantage in that the resultant silsesquioxane resin has high transparency to high energy, a high glass transition point (Tg), and a facility to control the acid generation from an acid generating agent during the PEB (Post-Exposure-Baking), is preferably selected.

The aforementioned cyclic saturated aliphatic hydrocarbon group is may be a monocyclic group or a polycyclic group. The polycyclic group may be the polycycloalkane groups including bicycloalkane, tricycloalkane, and tetracycloalkane, of which two hydrogen atoms have been removed and more specifically, the groups including adamantane, norbornane, isobornane, tricyclodecane, and tetracyclododecane, of which two hydrogen atoms have been removed.

These R₁₀ and R₁₂ are more specifically the alicyclic groups represented by the general formulae (33) to (38) or their derivatives, of which two hydrogen atoms have been removed.

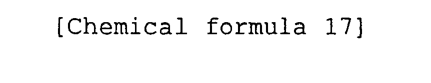

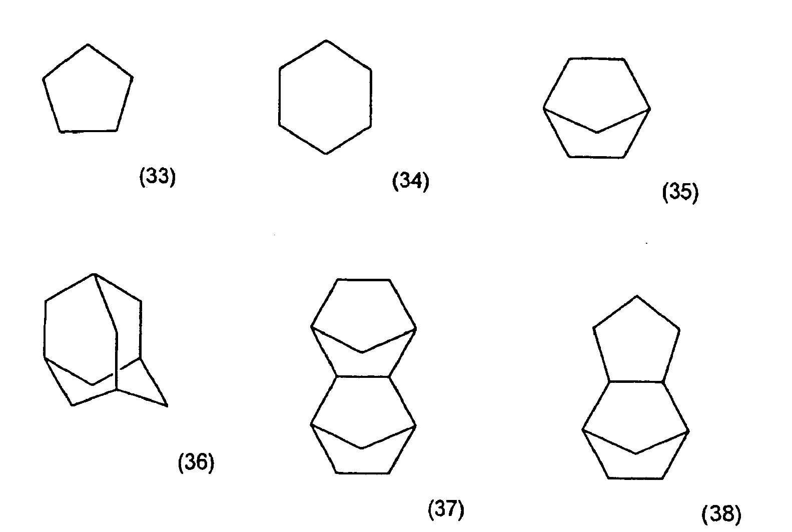

The aforementioned derivatives mean those in which at least one hydrogen atom has been substituted with a lower alkyl group such as methyl group and ethyl group, an oxygen atom, or a halogen atom such as fluorine, chlorine, and bromine in the alicyclic groups represented by the aforementioned chemical formulae (33) to (38). Among others, the alicyclic groups selected from a group consisting the chemical formulae (33) to (38), of which two hydrogen atoms have been removed, are preferably selected because of their higher transparency and easiness to industrial availability.

In addition, the aforementioned R₁₁ is preferable lower alkyl groups with 1 to 10 carbon atoms, and preferably 1 to 4 carbon atoms in terms of solubility to the resist solvent. Specifically, this type of alkyl groups are exemplified by a methyl group, ethyl group, propyl group, an isopropyl group, a n-butyl group, sec-butyl group, tert-butyl group, cyclopentyl group, cyclohexyl group, 2-ethylhexyl group, n-octyl group, or the like.

R₁₁ is selected from the aforementioned candidates depending on the desired alkali-solubility of silsesquioxane resin if appropriately. When R₁₁ is a hydrogen atom, alkali-solubility reaches the highest level. Higher alkali-solubility has an advantage in that sensitivity further improves.

On the other hand, as the number of the carbon atoms of the aforementioned alkyl group increases, making more and more bulky, alkali-solubility of silsesquioxane resin deteriorates. As alkali-solubility deteriorates, resistance to the alkali developing solution improves and therefore, a lithographic margin may be enhanced in forming the resist patterns using the silsesquioxane resin and a variation in size involved with light exposure reduces. Furthermore, the problem of unevenness in development may be eliminated, roughness in the edges of the resist patterns is improved.

In the aforementioned general formulae (26) and (27), preferably, X is in particular a linear alkyl group. Preferably, lower alkyl groups with 1 to 8 carbon atoms or preferably 1 to 4 carbon atoms are selected in terms of the glass transition point (Tg) of silsesquioxane resin and solubility to the resist solvent. The alkyl groups, in which more number of hydrogen atoms have been substituted with the fluorine atoms, have higher transparency to a high energy beam or electron beam emitted at a wavelength lower than 200 nm, and is preferably selected. Furthermore, the perfluoroalkyl group, in which all the hydrogen atoms have been substituted with the fluorine atoms, is most preferable. Each X may be the same or different from each other. In the general formula (26), m is any integer in the range from 1 to 3, and preferably 1 to make the acid-dissociative dissolution inhibiting group easy to dissociate.

Silsesquioxane resins are more specifically exemplified by the following general formulae (39) and (40).

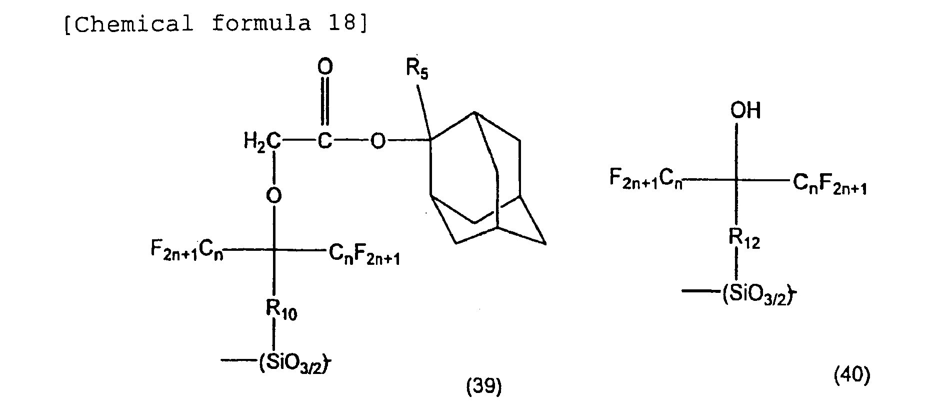

In the general formulae (39) and (40), R₅, R₁₀, R₁₂, and n are as defined in the descriptions above.

In all the constitutional units composing the silsesquioxane resin, the ratios of the constitutional units (a6) and (a7) are 30 to 100 mol%, preferably 70 to 100%, and more preferably 100 mol%, respectively.

The ratio of the constitutional unit (a6) to the total of the constitutional units (a6) and (a7) is preferably 5 to 70 mol% and more preferably 10 to 40 mol%. The ratio of the constitutional unit (a7) is preferably 30 to 95 mol% and more preferably 60 to 90 mol%.

By setting the ratio of the constitutional unit (a6) within the aforementioned range, the ratio of the acid-dissociative dissolution inhibiting group is determined by itself and therefore, a variation in alkali-solubility of the silsesquioxane resin before and after the lithography process becomes suitable for the base resin for the positive resist composition.

The silsesquioxane resin may have any constitutional units other than the constitutional units (a6) and (a7) to the extent that it does not depart from the effects of the present invention. For example, these constitutional units are exemplified by the constitutional units used in the silsesquioxane resin for resist composition for ArF excimer laser, for example, alkylsilsesquioxane units having any of the alkyl groups (R') including a methyl group, ethyl group, propyl group, and butyl group represented by the following general formula (41).

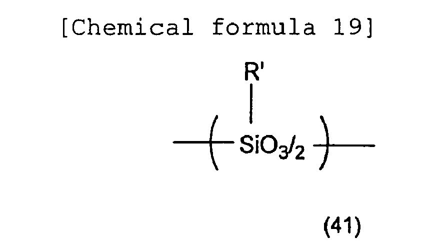

The weight-average molecular weight (Mw) of the silsesquioxane resins (converted into the polystyrene value by gel permeation chromatography) is not in particular limited but is preferably any of 2000 to 15000 and more preferably any of 3000 to 8000. The larger value than this range deteriorates solubility to the resist solvent, while the smaller value may make the cross sectional shapes of resist patterns poorer.

In addition, weight-average molecular weight(Mw)/number-average molecular weight (Mn), namely the degree of polymer dispersion is not in particular limited but is preferably any of 1.0 t 6.0 and more preferably any of 1.5 to 2.5. The larger value than this range may deteriorate resolution and pattern shapes.

The silsesquioxane resin is the polymer, which has slsesquioxanes composed of the constitutional units (a6) and (a7) in its skeleton and therefore, has high transparency to the high energy light beam or electron beam emitted at a wavelength lower than 200 nm. Accordingly, the positive resist composition containing the silsesquioxane resin is useful, for example, in the lithography process using the light source emitting a light beam at a shorter wavelength than that of ArF excimer laser and in particular, even in the single-layer process, enables finer resist patterns with line widths of 150 nm or less and further 120 nm or less to be formed. In addition, the positive resist composition may be used with an upper layer of a double-layer resist laminated body, enabling finer resist patterns with line widths less than or equal to 120 nm and further less than or equal to 100 nm.

Any of resin components may be used for the aforementioned negative resist composition with no limitation provided that the component is commonly used. Specifically, the following resin components may be preferably used.

For these type of resin components, such resin components (a8) that have two kinds of functional groups in a molecule, which may react with each other in their molecule to form ester, when an acid produced in the presence of the acid generating reagent added simultaneously to the resist material acts on it, the two kinds of functional groups are dehydrated to form ester, thereby turning the resin components to alkali-insoluble, is preferably used. The "two kinds of functional groups, which may react with each other in their molecules to form ester" described herein means the groups, for example, the hydroxyl group and the carboxyl group for forming carboxylic acid ester, or carboxylic acid ester. In other words, these groups are two kinds of functional groups for forming ester. Among these resin components, the components, for example, which have the hydroxyalkyl group and at least one of the carboxyl group and carboxylic acid ester group in the side chain of the main resin skeleton, are preferable used.
In addition, for the aforementioned resin components, the resin component (a9), which is composed of a polymer having a dicarboxylic acid monoester unit, is preferable used.

In other words, the aforementioned (a8) is the resin component, which has at least the constitutional unit represented by the following general formula (42).

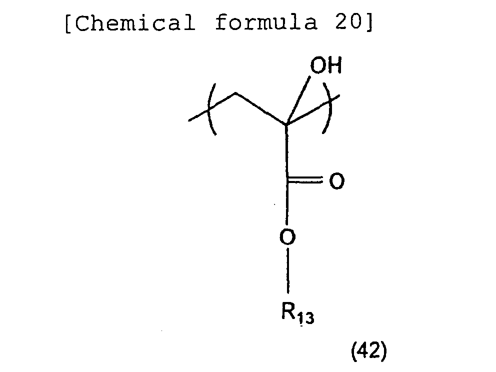

In the general formula (42), R₁₃ is a hydrogen atom, alkyl group with C1 to C6, or the alkyl group having any of the polycyclic skeletons including a bolnyl group, an adamantyl group, a tetracyclododecyl group, and tricyclodecyl group.

Preferable Examples of these resin components include a polymer (homopolymer or copolymer) (a8-1) of at least one of monomer selected from α-(hydroxyalkyl)acrylic acid and a-(hydroxyalkyl)acrylic acid alkyl ester; and a copolymer (a8-2) of at least one of monomers selected from α-(hydroxyalkyl)acrylic acid and a-(hydroxyalkyl)acrylic acid alkyl ester and at least one of monomer selected from an ethylenated unsaturated carboxylic acid and ethylenated unsaturated carboxylic acid ester.

For the aforementioned polymer (a8-1), a copolymer of α-(hydroxyalkyl)acrylic acid and α-(hydroxyalkyl)acrylic acid alkyl ester is preferably used, and for the copolymer (a8-2), at least one monomer selected from acrylic acid, methacrylic acid, acrylic acid alkyl ester, and methacrylic acid alkyl ester is preferably used for the other aforementioned ethylenated unsaturated carboxylic acid or ethylenated unsaturated carboxylic acid ester.

Examples of the hydroxyalkyl group in the aforementioned α-(hydroxyalkyl)acrylic acid or α-(hydroxyalkyl)acrylic acid alkyl ester include lower hydroxyalkyl groups including the hydroxymethyl group, the hydroxyethyl group, the hydroxypropyl group, and the hydroxybutyl group. Among these groups, the hydroxyethyl group and the hydroxymethyl group are preferably used because of their easiness to form ester.

Examples of the alkyl group at the alkyl ester site of α-(hydroxyalkyl)acrylic acid alkyl ester include the lower alkyl groups including a methyl group, an ethyl group, a propyl group, an isopropyl group, a n-butyl group, sec-butyl group, tert-butyl group and an amyl group; and cross-linked polycyclic hydrocarbon groups including a bicyclo[2.2.1]heptyl group, bolnyl group, an adamantyl group, a tetracyclo[4.4.0.1^{2.5}.1^{7.10}]dodecyl group, and tricyclo[5.2.1.0^{2.6}]decyl group. If the alkyl group at the ester site has the polycyclic hydrocarbon group, resistance to dry etching is effectively improved. Among these alkyl groups, in particular, lower alkyl groups, which are inexpensive components for forming ester and easily available, including the methyl group, the ethyl group, the propyl group, the butyl group are preferably used.

When any of lower alkyl esters is used, an esterification occurs with the hydroxyalkyl group as in the carboxyl group, while such an esterification is difficult to occur when an ester is formed with the cross-linked plycyclic hydrocarbon. For this reason, when an ester of the cross-linked plycyclic cyclic hydrocarbon is introduced into the resin component, it is preferable that the carboxyl group is simultaneously connected to the side chain of the resin.

On the other hand, examples of other ethylenated unsaturated carboxylic acids or ethylenated unsaturated carboxylic acid esters in the aforementioned (a8-2) include unsaturated carboxylic acids such as an acrylic acid, a methacrylic acid, maleic acid, and fumaric acid; and alkyl esters such as methyl, ethyl, propyl, isopropyl, n-butyl, isobutyl, n-hexyl and octyl ester of these unsaturated carboxylic acids. For the alkyl group at the ester site, acrylic acid ester or methacrylic acid ester having the cross-linked polycyclic hydrocarbon group may be used including a bicyclo[2.2.1]heptyl group, bolnyl group, an adamantyl group, a tetracyclo[4.4.0.1^{2.5}.1^{7.10}]dodecyl group, and tricyclo[5.2.1.0^{2.6}]decyl group. Among these alkyl groups, acrylic acid and methacrylic acid or their lower alkylesters including methyl, ethyl, propyl, and n-butylester are preferably used.

In the aforementioned resin component (a8-2), the ratio of at least one of monomer unit selected from α-(hydroxyalkyl)acrylic acid and α-(hydroxyalkyl)acrylic acid alkyl ester and at least one of monomer unit selected from other ethylenated unsaturated carboxylic acid and ethylenated unsaturated carboxylic acid ester is preferably within a range of 20:80 to 95:5, in particular 50:50 to 90:10 based on molar ratio. If the ratio between the monomer units is within the aforementioned range, intra- or inter-molecular ester bond may be easily forms, achieving superior resist patterns.

The aforementioned resin component (a9) is the resin component having at least the constitutional unit represented by the following general formula (43) or (44).

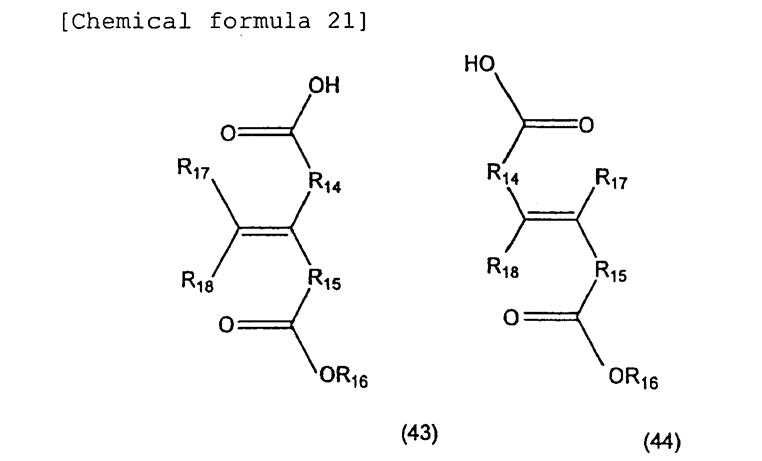

In the general formulae (43) and (44), R₁₄ and R₁₅ are an alkyl chain with 0 to 8 carbon atoms, R₁₆ is the substituent having at least two or more alicyclic structures, R₁₇ and R₁₈ are a hydrogen atom or an alkyl group with 1 to 8 carbon atoms.

The negative resist composition using the resin component having this type of dicarboxylic acid monoester monomer unit is preferably used because of its higher resolution and reduced line edge roughness. This composition, which has resistance to swelling, is more preferably used in the liquid immersion lithography process. These dicarboxylic acid monoester compounds include fumaric acid, itaconic acid, mesaconic acid, glutaconic acid, and traumatic acid.

In addition, preferable examples of the resins having the aforementioned dicarboxylic acid monoester unit include the polymer or the copolymer (a9-1) of dicarboxylic acid monoester monomers; and the copolymer (a9-2) of dicarboxylic acid monoester monomer and at least one monomer selected from the aforementioned α-(hydroxyalkyl)acrylic acid, α-(hydroxyalkyl)acrylic acid alkyl ester, other ethylenated unsaturated carboxylic acid and ethylenated unsaturated carboxylic acid ester. The resin component for the aforementioned negative resist composition may be used alone or by combining two or more. The weight-average molecular weight of the resin component is any of 1000 to 50000 and preferably any of 2000 to 30000.

In the aforementioned resins, the positive resists using the acrylic resin ((a1) to (a4)) are the positive resists containing the resins with relatively high resistance to liquid immersion but as the size closes to the limit resolution size in liquid immersion lithography, pattern resolution tends to deteriorate. The factors inducing this deteriorated resolution is not limited to one factor and to avoid these factors, it is very useful that the protective film of the present invention is formed to fully separate between the liquid immersion liquid and the resist film.

The positive resists using silsesquioxane resins ((a6) and (a7)) or the negative resists using certain kinds of resins (a8) and/or (a9) may have lower resistance to liquid immersion than the positive resists using the aforementioned acrylic resins and the use of the protective film of the present invention may improve the applicability to liquid immersion lithography.

Moreover, it is known that when the cycloolefin resins are used, resistance to liquid immersion is very low, disturbing patterns from being formed. Even the positive resists containing these types of resins are used, the use of the protective film of the present invention enables the resists to be applied to liquid immersion lithography.

Furthermore, for the acid generating reagents combined with the resist compositions for the aforementioned positive resists or negative resists, any one may be selected from the known acid generating reagents for conventional chemically amplified resists.

Actual examples of the aforementioned acid generating reagents include onium salts such as diphenyliodoniumtrifluoromethanesulfonate, (4-methoxyphenyl)phenyliodoniumtrifluoromethanesulfonate, bis(p-tert-butylphenyl)iodoniumtrifluoromethanesulfonate, triphenylsulfoniumtrifluoromethanesulfonate, (4-methoxyphenyl)diphenylsulfoniumtrifluoromethanesulfonate, (4-methylphen,yl)diphenylsulfoniumtrifluoromethanesulfonate, (4-methylphenyl))diphenylsulfoniumnonafluorobutanesulfonate, (p-tert-butylphenyl)diphenylsulfoniumtrifluoromethanesulfonate, diphenyliodoniumnonafluorobutanesulfonate, bis(p-tert-butylphenyl)iodoniumnonafluorobutanesulfonate, triphenylsulfoniumnonafluorobutanesulfonate, (4-trifluoromethylphenyl)diphenylsulfoniumtrifluoromethanesulf onate, (4-trifluoromethylphenyl)diphenylsulfoniumnonafluorobutanesulf onate, and tri(p-tert-butylphenyl)sulfoniumtrifluoromethanesulfonate.

Among the onium salts, a triphenylsulfonium salt, which is difficult to decompose and to produce organic gases, is preferably used. The blending amount of the triphenylsulfonium salt is preferably within any of 50 to 100 mol%, more preferably within 70 to 100 mol%, and most preferably 100 mol% to the total amount of the acid generating reagent.

Among the triphenylsulfonium salts, in particular, the triphenylsulfonium salt represented by the following general formula(45) having an perfluoroalkylsulfonic acid ion as an anion is preferably used because it makes sensitivity higher.

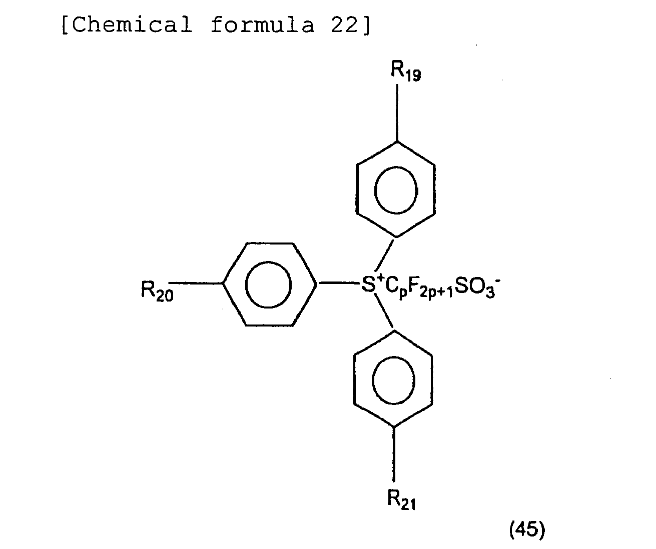

In the genera formula (45), R₁₉, R₂₀, and R₂₁ are independently a hydrogen atom, lower alkyl groups, with 1 to 8 carbon atoms, preferably 1 to 4 carbon atoms, or a halogen atom such as chlorine, fluorine, and bromine, respectively, p is any integer in the range from 1 to 12, preferably in the range from 1 to 8, and more preferably in the range of 1 to 4.

The aforementioned acid generating reagents may be used alone or by combining two or more. The blending amount of the acid generating reagent is 0.5 parts by mass and preferably 1 to 10 parts by mass to 100 parts by mass of the aforementioned resin components. At less than 0.5 parts by mass, patterning is not satisfactorily performed, while at more than 30 parts by mass, a homogeneous solution is difficult to be prepared, which may deteriorate stability under the condition of storage.

The aforementioned positive or negative resist composition is manufactured by dissolving the aforementioned resin components, the acid generating reagent, and any optional components described later preferably in the organic solvent.

For the organic solvent, any organic solvent may be used which may dissolve the aforementioned resin components and the acid generating reagent to make the solution homogeneous and any one, two or more solvents may be appropriately used by selecting from the known solvents for conventional chemically amplified resists.

For instance, examples of the organic solvent includes ketones such as an acetone, a methyl ethyl ketone, cyclohexanone, methylisoamylketone, and 2-heptanone; polyhydric alcohols including an ethylene glycol, ethylene glycol monoacetate, a diethylene glycol, a diethylene glycol monoacetate, propylene glycol, propylene glycol monoacetate, dipropylene glycol, or a monomethyl ether, monoethyl ether, monopropyl ether, monobutyl ether or monophenyl ether of dipropylene glycol mono acetate; and their derivatives; cyclic ethers such as a dioxane; and esters such as a methyl lactate, an ethyl lactate, a methyl acetate, an ethyl acetate, a butyl acetate, methyl pyruvate, an ethyl pyruvate, a methyl methoxypropionate, and an ethyl ethoxypropionate. These organic solvents may be used alone or by combing two or more.

In these positive or negative resists, an organic acid may be added including a known amine, preferably secondary lower aliphatic amine or tertiary lower aliphatic amine, organic carboxylic acid, or phosphorous oxo acid as a quencher to improve shapes of resist patterns and temporal stability.

The aforementioned lower aliphatic amine includes the amine of alkyl or alkyl alcohol with 5 or less carbon atoms, and the examples of secondary amine and tertiary amine include trimethylamine, diethylamine, triethylamine, di-n-propylamine, tri-n-propylamine, tripentylamine, diethanolamine, and triethanolamine and in particular, alkanolamines such as triethanolamine is preferably used. These aliphatic amines may be used alone or by combining two or more. These amines are usually used in any in the range from 0.01 to 2.0% by mass.

The suitable example of the aforementioned organic carboxylic acids include, for example, malonic acid, citric acid, malic acid, succinic acid, benzoic acid, and salicylic acid.

The aforementioned phosphorous oxo acid or its derivatives include phosphoric acid and derivatives thereof or its ester such as phosphoric acid, phosphoric acid di-n-butyl ester and phosphoric acid diphenyl ester; phosphonic acid and derivatives thereof or its ester such as phosphonic acid, phosphonic acid dimethyl ester, phosphonic acid di-n-butyl ester, phenylphosphonic acid, phosphonic acid diphenyl ester, and phosphonic acid dibenzil ester; and phosphinic acid and derivatives thereof and its ester such as phosphinic acid, phenylphosphinic acid. Among them, in particular, phosphonic acid is preferably used.

The aforementioned organic acid is used in a ratio of 0.01 to 5.0 parts by mass to the resin component 100 parts by mass. These organic acids may be used alone or by combining two or more. These organic acids are preferably used in the molar range lower than or equal to that of the aforementioned amine.

A miscible additives, for example, the surface active agent, a dissolution inhibiting agent, a plasticizer, a stabilizer, a coloring agent, and an antihalation agent may be added, if desired, to the positive resist composition for forming the resist film used in the liquid immersion lithography process of the present invention to improve the performance of the resist film.

Moreover, a crosslinking agent may be added in the negative resist composition for forming the resist film for liquid immersion lithography of the present invention to further improve the cross-linking density, enhancing the resist pattern shapes, resolution, and resistance to dry etching, if necessary.

For this crosslinking agent, any of known crosslinking agents, which is commonly used in the conventional chemically amplified negative resists, may be used with no special limitation. Example of these crosslinking agents include the aliphatic cyclic hydrocarbon or its oxygen-containing derivatives having the hydroxyl group or the hydroxyl alkyl group or both of these groups, such as 2,3-dihydroxy-5-hydroxymethylnorbornane, 2-hydroxy-5,6-bis(hydroxymethyl)norbornane, cyclohexanedimethanol, 3,4,8(or 9)-trihydroxytricyclodecane, 2-methyl-2-adamantanol, 1,4-dioxane-2,3-diol, and 1,3,5-trihydroxycyclohexane; and the compound, which is produced by causing the compound containing any of amino groups, such as melamine, acetoguanamine, benzoguanamine, urea, ethylene urea, or glycoluryl to react with formaldehyde or formaldehyde and lower alcohol, thereby substituting the hydrogen atoms of the amino group with the hydroxymethyl group or the lower alkoxymethyl group, and are specifically exemplified by hexamethoxymethylmelamine, bismethoxymethylurea, bismethoxymethylbismethoxyethylene urea, tetramethoxymethyl glycoluryl, and tetrabutoxymethyl glycoluryl. In particular, tetrabutoxymethyl glycoluryl is most preferably used. These crosslinking agents may be used alone or by combining two or more.

Additionally, the dissolution inhibiting agent, which is a low-molecular weight compound, being dissolved in the presence of an acid (for example, hydrolysis), resulting in improved alkali-solubility, may be added. The dissolution inhibiting agent may inhibit the dissolution action of the developing solution on the insoluble portion after the lithography process. If the resist is somewhat overdeveloped, first the pattern top tends to dissolve at the corners and the addition of the dissolution inhibiting agent may be added to prevent the aforementioned pattern top from being dissolved, ensuring suitable pattern contrast.

The dissolution inhibiting agent used for the resist film material includes, for example, a compound, which may be dissolved into the functional group of the phenolic hydroxyl group, alcoholic hydroxyl group, carboxyl group having at least one aromatic ring or aliphatic ring with molecular weight of 200 to 500, and one or more substituents having dissolution inhibiting ability to alkali have been introduced. These acid-dissociative substituent includes, for example, a tertiary alkyl group, tertiary alkoxycarbonyl group, tertiary alkoxycarbonyl alkyl group, and chain or cyclic alkoxyalkyl groups.

Specifically, the tertiary alkyl groups such as a tert-butyl group, tertiary alkoxycarbonyl groups such as a butoxycarbonyl group, tertiary alkoxycarbonyl alkyl group such as a tert-butoxycarbonylmethyl group, methoxymethyl group, chain alkoxyalkyl group such as a 1-ethoxyethyl group, 1-propoxyethyl group, and cyclic alkoxyalkyl group such as a tetrahydropyranyl group and tetrahydrofranyl group.

These dissolution inhibiting agents include the compound, in which the hydrogen atoms of the carboxyl group of the bile acid such as lithocholic acid have been substituted with the tertiary alkyl group and the following compound (dissolution inhibiting agent) having the fluorine atom. In particular, the latter compound having the fluorine atom is preferable because of its superior pattern shapes. The dissolution inhibiting agent contains the fluorine atom and therefore, preferably, transparency to the F₂ excimer laser beam is improved, achieving superior resist pattern shapes.

The acid-dissociative substituents of these dissolution inhibiting agents include, for example, a tertiary alkyl group, tertiary alkoxycarbonyl group, tertiary alkoxycarbonyl alkyl group, and the chain or cyclic alkoxyalkyl group. Specifically, these substituents include the tertiary alkyl group such as a tert-butyl group, tertiary alkoxycarbonyl group such as a tert-butoxycarbonyl group, the tertiary alkoxycarbonyl alkyl group such as tert-butoxycarbonylmethyl group, and the chain, branch or cyclic alkyloxymethyl groups with 1 to 15 carbon atoms such as a methoxymethyl group, tert-amyloxymethyl group, 4-tertbutyl-cyclohexyloxymethyl group.

The appropriate amount of added dissolution inhibiting agent in the resist composition is 2 to 30 parts by weight and preferably 3 to 10 parts by weight relative to the main component polymer 100 parts by weight.

(IV) Method of forming resist patterns
Now, the method of forming resist patterns using the protective film of the present invention in the liquid immersion lithography process is described.
First, the commonly used resist composition is applied on a substrate such as a silicon wafer with a spinner or the like, and then the substrate is pre-baked (PAB process).
Alternatively, two-layer laminated body with an inorganic antireflection film laid between the substrate and the coated layer of the resist composition may also be used.

Up to this process may be performed by the known method. The operating conditions are preferably set depending on the constitution and characteristics of the resist composition.

Next, the protective film forming material of the present invention is homogeneously applied to the surface of the resist film (single-layer, multi-layer) cured as described above and then the film is left for curing for forming the resist protective film.

The substrate, of which resist film is covered with the protective film in this way, is immersed in the non-aqueous refractive index liquid (liquid having a larger refractive index than that of the air).

The light bean is selectively irradiated onto the resist film of the substrate immersed in the liquid through the desired mask patterns. Accordingly, in this case, the exposing light beam passes through the refractive index liquid and the protective film to arrive at the resist film.

At this time, the resist film is completely blocked from the refractive index liquid by the protective film and accordingly, is not degenerated due to invasion of the refractive index liquid such as swelling and does not dissolves into the refractive index liquid, causing the optical characteristics such as refractive index of the refractive index liquid to deteriorate.

In this case, any wavelength of the exposing light beam may be used with no limitation and any radiation ray may be used including ArF excimer laser, KrF excimer laser, F₂ excimer laser, EUV (Extreme Ultra Violet), VUV (Vacuum Ultra Violet), electron beam, X-ray, and soft X-ray. The radiation ray to be selected depends mainly on the characteristics of the resist film.

As described above, in the method of forming the resist patters of the present invention, the non-aqueous solution (refractive index liquid) with a refractive index higher than that of the air is laid on the resist film in the lithography process. These non-aqueous solution (refractive index liquid) includes, for example, fluorinated liquids.

Any refractive index may be used for the non-aqueous solution (refractive index liquid) with no limitation provided that the index is "at the level lower than that of the air". If a non-aqueous solution with a refractive index of at least 1.5 and preferably 1.7 or higher is put into practical use in the future. Not only this new non-aqueous solution is improved, but also it is predicted that the wavelength of the exposing light beam is significantly shrunk, and therefore, the present invention will exhibit its best effect.

Once the lithography process has been finished with the resist film immersed condition, PEB (Post-Exposure Bake) is applied to the exposed resist film and then the resist film is developed using the alkali developing solution composed of an alkali aqueous solution, and the protective film is removed coincidentally with the development process. PEB described herein may be applied prior to the protective film peeling process. Moreover, the development process may be followed by the post bake process. Preferably, the resist film is rinsed using deionized water. In this water rinse step, for example, water is dripped or sprayed on the substrate while the substrate is being turned to wash away the developing solution and the residue resist composition dissolved by the developing solution on the substrate. Then, the resist film is dried to obtain the resist patterns exactly similar to that of mask patterns.

By forming the resist patterns in this way, the resist patterns with fine line widths, and in particular, line-and-space-patterns may be formed at a superior resolution. Herein, a pitch in the line-and-space-patterns is the total distance of the resist pattern width and the space width in the direction of the line width of patterns.

### Examples

Now, based on the examples, the present invention is described in detail. It should be noted that the present invention is not limited to the following examples.

### Evaluation test 1

### (Example 1)

The following resin component, the acid generating reagent, and nitrogen containing organic compound are homogeneously dissolved in the organic solvent to prepare the positive resist composition 1. For the resin component, 100 parts by mass of a copolymer composed two constitutional units represented by the following chemical formulae (46) and (47) was used. The ratios of constitutional units (m and n) used in preparing the resin components were m=50mol% and n=50mol%. The weight-average molecular weight of the resin components prepared was 10000.

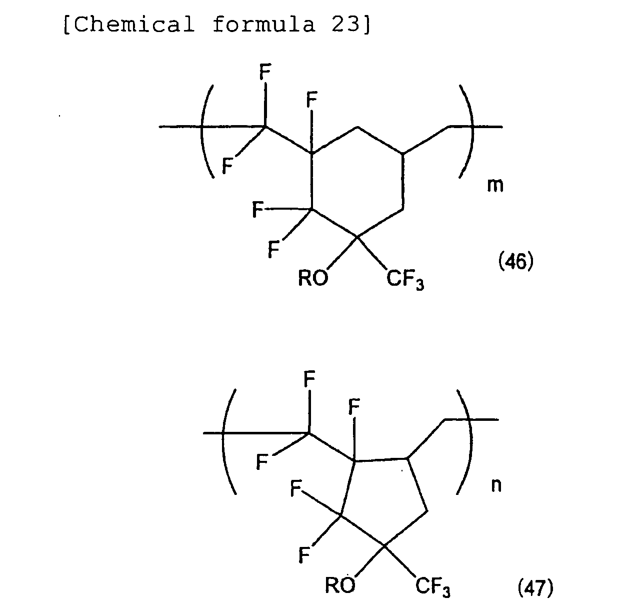

In the general formulae (46) and (47), R is - CH₂OCH₃ or -H and the ratios between the -CH₂OCH₃ group and -H are 20% and 80%, respectively.

For the aforementioned acid generating reagent, the chemical compound represented by the following chemical formula (48) was used in an amount of 5.0 parts by mass.

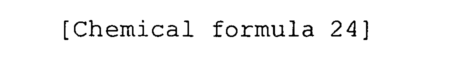

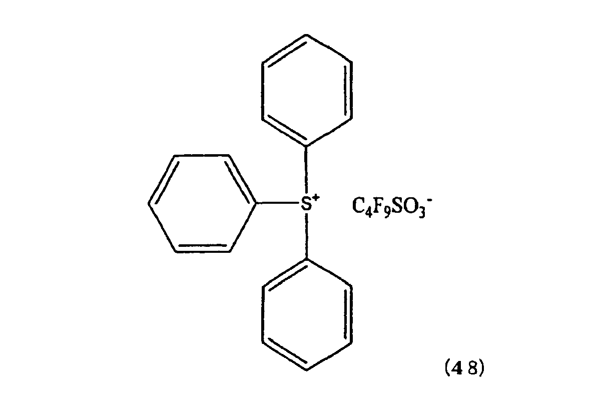

For the aforementioned organic solvent, propylene glycol monomethylether acetate (PGMEA) was used.
Moreover, for the aforementioned nitrogen containing organic compounds, 0.4 parts by mass of triisopropanol amine and 0.1 parts by mass of salicylic acid were used.
Furthermore, for the dissolution inhibiting agent, 5 parts by mass of fluorine compound represented by the following chemical formula (49) was used.

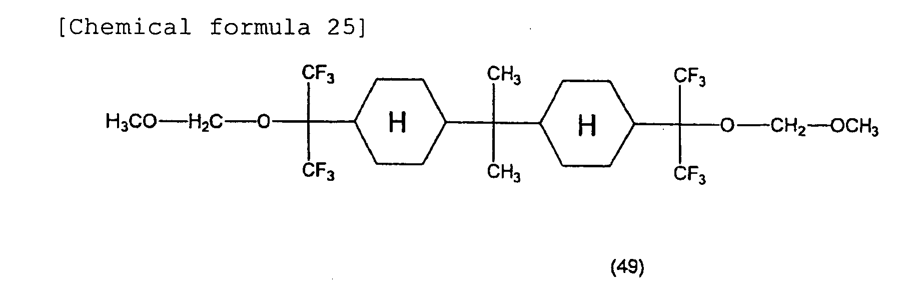

The positive resist composition 1 prepared as described above was used to form the resist patterns. First, an organic antireflective film composition "AR-19" (product name, manufactured by Shipley Co., Ltd.) was applied on the silicon wafer using a spinner and then the wafer was baked on a hot plate at 215°C for 60 seconds for drying to form an 82 nm-thickness of organic antireflective film. Then, the aforementioned positive resist composition 1 was applied on the antireflective film using the spinner and then the antireflective film was baked on the hot plate at 90°C for 90 seconds for drying to form a 250 nm-thickness of resist film on the antireflective film.

At the same time, 500 g of 20% by weight EF-101 (manufactured by Tokemu Products Co., Ltd.) aqueous solution, namely perfluorooctyl sulfonic acid (C₈F₁₇SO₃H) and 80 g of 20% by weight monoethanolamine aqueous solution were mixed. 25 g of the mixed solution was added to the 20 g of 10 % by weight polyvinylpyrrolidone aqueous solution and deionized water was added to the resultant aqueous solution to prepare 200 g of resist protective film forming material for liquid immersion lithography. The pH value for the resist protective film forming material for liquid Immersion lithography was 2.7.

The aforementioned resist protective film forming material was applied on the aforementioned resist film and then the resist film was baked at 90°C for 90 seconds for drying to form 65 nm-thickness resist protective film.

Next, a patterning light beam was irradiated (exposed) through the mask pattern using ArF excimer laser (wavelength; 193 nm) on a photolithography apparatus NSR-S302B (Nikon Corporation, NA (numerical aperture)=0.60, σ=0.75). Then, the film was further developed in an alkali developing solution composed of 2.38 % by mass of tetramethylammonium aqueous solution at 23°C for 60 seconds.

The resist patterns, of which 130 nm of line-and-space was 1:1, thus obtained was observed under scanning electron microscope (SEM). The result showed that the pattern profile was excellent with no fluctuation. The sensitivity to exposing light beam (Esize) was 18.55 mJ/cm².

### (Example 2)

The amount of monoethanolamine was reduced from the resist protective film forming material for liquid immersion lithography used in Example 1 to prepare the material, the pH value of which was 2.49.

With an exception that this resist protective film forming material of pH 2.49 was used, the resist patterns obtained in the same manner as that in the Example 4 as described later, of which 130 nm line-and-space was 1:1, was observed under scanning electron microscope (SEM). The result showed that the pattern profile indicated superior pattern shapes with negligible reduction in thickness of the patterned film and no fluctuation. The sensitivity to exposing light beam (Esize) was 13.21 mJ/cm² and a variation from the sensitivity in the usual dry process was 2.6% and a variation from the sensitivity in the case where fluorinated liquid was not dripped was negligible.

### (Example 3)

In the same manner as that of the Example 1, the resist protective film was formed and the patterning light beam was irradiated (exposed). Next, perfluoro(2-butyl tetrahydrofuran), a fluorinated liquid, was dripped on the resist film at 23°C for one minute while the silicon wafer with the resist film covered on it was being turned in the liquid immersion lithography process. In this step of the actual manufacturing process, the light beam is irradiated on the film with completely immersed in the liquid. However, based on the previous analysis on the liquid immersion lithography process, it was demonstrated that exposure by the optical system was completely performed. This might be established theoretically and therefore, it has been simply configured so that the light beam was irradiated on the resist film in advance and the fluorinated liquid, namely the refractive index liquid (liquid immersion liquid) is applied on the resist film after exposure to evaluate only the effects of the liquid immersion liquid on the resist film. Subsequently, the experiment was performed in the same manner as that of the Example 1.

The resultant resist pattern, of which 130 nm line-and-space was 1:1, was observed under scanning electron microscope (SEM). The result showed that the pattern profile indicated superior pattern shapes with no fluctuation. The sensitivity to exposing light (Esize) was 18.54 mJ/cm² and a variation from the sensitivity in the usual dry process was 0.05% and almost no difference was observed compared with the case where fluorinated liquid was not dripped.

### (Example 4)

With an exception that perfluorotripropyleamine, namely a fluorinated liquid, was dripped for one minute in the liquid immersion lithography process, the experience was performed in the same manner as that of the Example 3.

The resist patters, of which 130 nm line-and-space was 1:1 was observed under running electronic microscopy (SEM). The result showed that the pattern profile indicated superior pattern shapes with no fluctuation. The sensitivity to exposing light (Esize) was 19.03 mJ/cm² and a variation in sensitivity from the sensitivity in the usual dry process 2.6% and a variation from the case where the fluorinated liquid was not dripped was negligible.

### Evaluation test 2

### (Example 5)

100 parts by weight of resin components represented by the general formulae (46) and (47) used for the positive resist composition in the Example 1, 2.0 parts by weight od triphenylsulfoniumnonafluorobutane sulfonate, namely an acid generating reagent, and 0.6 parts by weight of tridodecylamine, namely amine were dissolved to prepare solid concentration of 8.5% by weight propylene glycol monomethyl ether acetate solution. The positive resist composition as a homogeneous solution was obtained.

The positive resist composition prepared as described above was used to form the resist patterns. First, an organic antireflective composition "AR-19" (product name, manufactured by Shipley Company L.L.C) was applied on the silicon wafer using the spinner and the wafer was baked on the hot plate at 215°C for 60 seconds for drying to form 82 nm-thickness organic antireflective film. The resultant positive resist composition was applied on the antireflective film using the spinner and then the film was baked on the hot plate at 95°C for 90 seconds for drying to form 102 nm-thickness resist layer on the antireflective film. Then, the resist protective film forming material used in the Example 2 was applied between the resist film and the fluorinated solvent and then heated at 95°C for 60 seconds for drying to form 35 nm-thickness protective film.

With respect to liquid immersion lithography, by using a prism and a fluorinated solvent composed of perfluorotripropylamine, 193 nm two-beam interference experiment (two-beam interference experiment) was performed on the experimental apparatus made by Nikon Corporation. The similar method is disclosed in the aforementioned non-patent document and is known to be the method, which enables L&S patterns to be easily obtained in a laboratory.

In the liquid immersion lithography according to the Example 5, the aforementioned fluorinated solvent layer was formed as an immersion solvent between the top of the protective film and the bottom of the prism.
The amount of exposing light beam, which was selected so that the L&S patterns might be stably obtained, the light beam was irradiated on the film through the mask, the aforementioned fluorinated solvent was wiped away, and PEB was applied to the film at 115°C for 90 seconds. Then, the film was developed in the 2.38% by mass of tetramethylammoniumhydroxide aqueous solution at 23°C for 60 seconds.

The result showed that 90 nm line-and-space (1:1) was achieved. The sensitivity was 10.4 mJ/cm² with superior rectangular pattern shapes.

### (Example 6)

With an exception that the thickness of resist film was changed from 102 nm to 125 nm, the patterns were formed using the two-beam interference experiment in the same manner as that in the Example 4.

The result showed that 65 nm line-and-space (1:1) was achieved. The sensitivity was 7.3 mJ/cm² with superior rectangular pattern shapes.

### (Example 7)

The positive resist composition used in the Example 6 was changed to the following the positive resist composition, in which the resin components, the acid generating reagent, and nitrogen containing organic compound were homogeneously dissolved into the organic solvent. With an exception that the pre-baking temperature was set to 125°C and the resist film thickness was changed to 95 nm, the patters were formed using the two-beam interference experiment in the same manner as that of the Example 6.

For the resin components of the aforementioned positive resist components, 100 parts by mass of copolymer of methacrylate ester and acrylate ester composed of three constitutional units represented by the following general formulae (50), (51), and (52) was used. The ratios p, q, r of constitutional units used in preparing the resin were p=50 mol%, q=30 mol%, and r=20 mol%, respectively. The weight-average molecular weight of the prepared resin component was 10000.

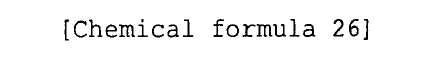

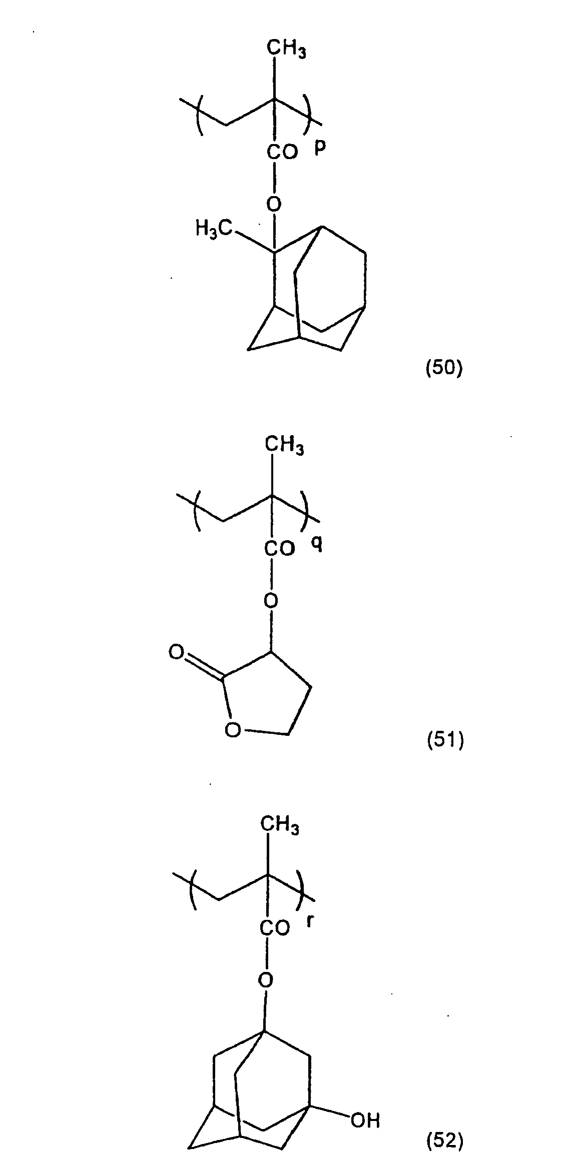

For the acid generating reagent, 3.5 parts by mass of triphenylsulfoniumnonafluorobutanesulfonate and 1.0 parts by mass of (4-methylphenyl)diphenylsulfoniumtrifluoromethanesulfonate were used. For the organic solvent, 1900 parts by mass of mixed solvent (mass ratio 6:4) of propylene glycol monomethyletheracetate and ethyl lactate was used. In addition, for the aforementioned nitrogen containing organic compound, 0.3 parts by mass of triethanol amine was used.

The result showed that 90 nm line-and-space (1:1) was achieved. The sensitivity was 14.8 mJ/cm² with superior rectangular pattern shapes.

### (Comparative example 1)

100 parts by weight of resin components represented by the general formulae (46) and (47) used for the positive resist composition in the Example 1, 2.0 parts by weight of triphenylsulfoniumnonafluorobutanesulfonate as the acid generating reagent, and 0.6 parts by weight of tridodecylamine, namely amine were dissolved to prepare the propylene glycol monomethyletheracetate solution with 8.5 % by weight of the solid concentration, thereby obtaining the positive resist composition as a homogeneous solution.

The positive resist composition prepared as described above was used to form the resist patterns. First, the organic antireflective film composition "AR-19" (product name, manufactured by Shipley Co., Ltd.) was applied on the silicon wafer using the spinner and then the wafer was baked on the hot plate at 215°C for 60 seconds for drying to form 82 nm-thickness organic reflective film. The positive resist composition obtained above was applied on the antireflective film using the spinner, and then the film was pre-baked on the hot plate at 95°C for 90 seconds for drying to form 102 nm-thickness resist later on the antireflective film.

With respect to liquid immersion lithography, by using the prism and the fluorinated solvent composed of fluorotripropylamine, 193 nm two-beam interference experiment (two beam interference method) was performed on the experimental apparatus made by Nikon Corporation. The similar method is disclosed in the aforementioned non-patent document 2 and is known for obtaining easily the L&S patterns in the laboratory.

In the liquid immersion lithography process in the comparative example 1, the aforementioned fluorinated solvent layer was formed between the top of the protective film and the bottom of the prism as the immersion solvent.
The amount of exposed light beam was selected so that L&S patterns might be stably obtained, the light beam was irradiated through the mask, the aforementioned fluorinated solvent was wiped away, and then PEB was applied at 115°C for 90 seconds. Thereafter, the film was developed at 23°C for 60 seconds in 2.38 % by mass tetramethylammonium hydroxide solution.

The result showed that 65 nm line-and-space (1:1) was achieved. The sensitivity was 11.3 mJ/cm² with superior patter shapes but the top was slightly T-shaped.

### Evaluation test 3

### (Example 8)

The resist protective film forming material for liquid immersion lithography used in the Example 1 was applied on the quartz substrate while being rotated and the substrate was heated at 60°C for 60 seconds to form the 40 nm-thickness resist protective film. This film is referred to as an unexposed protective film. On the other hand, the light beam was irradiated on a large area (approximately 10 mm²), which may be visually checked, on the aforementioned resist protective film on the photolithographic apparatus NSR-S302B (made by Nikon Corporation, NA (numerical aperture)=0.60,a=0.75) using the ArF excimer laser (193 nm). The amount of exposed light beam was 40 mJ/cm². This film is referred to as an exposed protective film.

Next, the aforementioned unexposed film and the exposed film were immersed in perfluoro(2-butyltetrahydrofuran) and any variation in their thickness were measured in the immersed condition by using the RDA-QZ3 (lithotec Japan), which is a film thickness measurement device using a Quarts Crystal Microbalance under the measurement time for 60 seconds.

Variation in frequency on the quartz substrate was measured and obtained data was analyzed with the attached analysis software. To clarify any difference in film thickness between exposed samples and unexposed samples, when the film thickness becomes thinner, a negative value was used, while the film thickness becomes thick, a positive value was used, assuming that the immersion time 0 (zero) was the baseline. The time required for the actual immersion scanner, on which simulation is being conducted, to expose by one shot is 10 seconds and thereby, the variation in film thickness during 10 seconds was digitalized.

The result showed that the maximum variation for the unexposed protective film (10s) was -2.75nm, while the maximum variation for the exposed protected film (10s) was 2.09, preferable results were achieved in both of films. In this experiment, it was assumed that if an increase or decrease in the protective film was within ±5 nm, the result was satisfactory.

### (Experiment 9)

With an exception that for the liquid immersion liquid, perfluorotripropylamine was used, this experiment was conducted in the same manner as that of Example 8. The result showed that the maximum variation for the unexposed protective film (10s) was 2.22 nm, while the maximum variation for the exposed protective film (10s) was 0.51, both achieving satisfactory results.

### (Example 10)

The amount of monoethanolamine was decreased from the material for forming the protective film for liquid immersion lithography used in the Example 1 to prepare the material, the pH value of which was 2.77. With an exception that the resist protective film forming material of pH 2.77 was used, the experiment was conducted in the same manner as that in the Example 4. Then, the resist patterns, of which line-and-space was 1:1, were observed under scanning electronic microscope (SEM). The result showed that the pattern profile indicated satisfactory shapes with negligible reduction in thickness of the patterned film and no fluctuation. The sensitivity to exposing light beam (Esize) was 13.16 mJ/cm² and a variation in sensitivity from the sensitivity in the usual dry process was 1.0% and a variation from the sensitivity in the case where fluorinated liquid was not dripped was negligible.

### [Industrial applicability]

As mentioned above, the resist protective film forming material for liquid immersion lithography of the present invention is useful in the liquid immersion lithography process and in particular, suitable for the liquid immersion lithography process, in which a light beam is selectively irradiated on a resist film through a non-aqueous solution.

## Claims

1. A resist protective film forming material for a liquid immersion lithography process for forming the resist protective film suitably used for the liquid immersion lithography process, in which a light beam is selectively irradiated on the resist film through a non-aqueous solution, comprising:
at least one component selected from water-soluble and alkali-soluble film forming components.

2. The resist protective film forming material for a liquid immersion lithography process according to claim 1, wherein the liquid immersion lithography process improves the resolution of resist patterns by irradiating a light beam on a resist film interposing a given thickness of the non-aqueous solution with a refractive index higher than that of the air at least on the resist film in a path, along where the lithography exposing light beam passes to the resist film.

3. The resist protective film forming material for a liquid immersion lithography process according to claim 1, further comprising at least one component selected from an acid generating reagent and acidic compound.

4. The resist protective film forming material for a liquid immersion lithography process according to claim 3, wherein the acidic compound is at least one compound selected from a carboxylic acid, sulfonic acid and sulfonyl compound containing at least a fluorinated hydrocarbon group.

5. The resist protective film forming material for a liquid immersion lithography process according to claim 4, wherein the acidic compound is at least one compound selected from a compound represented by the following general formula (1):
R₁fCOOH (1)
(in the general formula (1), R₁f is a fluorinated hydrocarbon group, where a part of or all of the hydrogen atoms of a saturated or unsaturated hydrocarbon group containing 1 to 20 carbon atoms are substituted with fluorine atoms),
a compound represented by the following general formula (2):
R₁fSO₃H (2)
(in the general formula (2), the definition of R₁f is same as described above), and
a compound represented by the following general formula (3):
R₂f(SO₂R₁f)n (3)
(in the general formula (3), the definition of R₁f is same as above, R₂f is a fluorinated hydrocarbon group or a fluorinated amino group, where the hydrogen atoms of a saturated or unsaturated hydrocarbon group containing 1 to 20 carbon atoms are substituted with fluorine atoms or a hydrocarbon group or an amino group with no substitution, and n is an integer from 1 to 4).

6. The resist protective film forming material for a liquid immersion lithography process according to claim 1, further comprising a nitrogen containing compound.

7. The resist protective film forming material for a liquid immersion lithography process according to claim 6, wherein the nitrogen containing compound is at least one compound selected from quaternary ammonium hydroxide and alkanolamine compounds.

8. The resist protective film forming material for a liquid immersion lithography process according to claim 6, wherein the nitrogen containing compound is at least one compound selected from amino acid derivatives.

9. The resist protective film forming material for a liquid immersion lithography process according to claim 1, wherein the non-aqueous solution is a fluorinated liquid.

10. The resist protective film forming material for a liquid immersion lithography process according to claim 1, wherein the resist film, on which a protective film is formed, is formed by using a resist composition including:
(A) a polymer composed of an alkali-soluble constitutional unit (a1) containing an aliphatic cyclic group having both of (i) a fluorine atom or fluorinated alkyl group and (ii) alcoholic hydroxyl group, and an alkali-solubility of the polymer changes when an acid acts on it; and
(B) a resist composition containing an acid generating reagent when a light beam is irradiated.

11. The resist protective film forming material for a liquid immersion lithography process according to claim 1, wherein a pH value of the resist protective film forming material for a liquid immersion lithography process lies within the range from 2.4 to 2.8.

12. The resist protective film for a liquid immersion lithography process suitably used in the liquid immersion lithography process, in which a light beam is selectively irradiated on the resist film through the non-aqueous solution, the resist protective film is formed on the resist film using the resist protective film forming material according to claim 1.

13. A method of forming resist patterns using a liquid immersion lithography process comprising the steps of:
forming a resist film on a substrate;
forming a protective film composed of the resist protective film forming material according to claim 1 on the resist film;
laying a given thickness of non-aqueous solution for liquid immersion lithography directly on at least the protective film of the substrate, on which the resist film and the resist protective film are formed;
selectively irradiating a light beam on the resist film through the non-aqueous solution for liquid immersion lithography and the protective film, and subjecting a heat treatment if necessary; and
developing the resist film after irradiation and simultaneously removing the protective film to obtain resist patterns.
